# EUROPÄISCHE PATENTSCHRIFT

(11) **EP 3 992 091 B1**
(45) Veröffentlichungstag und Bekanntmachung des Hinweises auf die Patenterteilung: **29.04.2026**
(21) Anmeldenummer: 21198901.7
(22) Anmeldetag: 24.09.2021
(51) Int. Cl.: G06Q 10/20, B64F 5/60, H04L 67/12, B64D 11/02, B64D 11/06, G05B 19/418

(54) **VERFAHREN ZUM VERARBEITEN VON KENNUNGEN**
METHOD FOR PROCESSING IDENTIFIERS
PROCÉDÉ DE TRAITEMENT DES IDENTIFIANTS

(30) Priorität: 29.10.2020 DE 102020128551
(43) Veröffentlichungstag der Anmeldung: 04.05.2022
(73) Patentinhaber: Airbus Operations GmbH, 21129 Hamburg (DE)
(72) Erfinder: WALLER, Christian, 21129 Hamburg (DE); MÜLLER, Jan, 21129 Hamburg (DE); SCHWARK, Uwe, 21129 Hamburg (DE); CHEN, Bing, 21129 Hamburg (DE); FISCHER, Wolfgang, 21129 Hamburg (DE); TILLACK-NIEVELER, Christoph, 21129 Hamburg (DE)
(74) Vertreter: Bird & Bird LLP - Hamburg

(56) Entgegenhaltungen:
- US-A1- 2014 361 074
- US-A1- 2015 269 787
- US-A1- 2017 199 520
- US-A1- 2018 322 714

## Beschreibung

Kennungen sind grundsätzlich aus dem Stand der Technik bekannt. Unter einer Kennung wird vorzugsweise ein Kennzeichen oder ein Identifikator verstanden. Mittels der Kennung kann ein Objekt, das die Kennung trägt, beispielsweise identifiziert werden. Es ist jedoch auch möglich, dass eine von einem Objekt getragene Kennung über bestimmte Merkmale des Objekts Auskunft gibt. So kann eine Kennung beispielsweise ein Typ des Objekts oder technische Eigenschaften des Objekts repräsentieren. Über die Kennung können jedoch auch andere Merkmale bestimmt sein, die nicht das Objekt repräsentieren, sondern die mit dem Objekt in Verbindung stehen.

Beispielsweise ist aus der US 2017/199520 A1 ein Verfahren zur Erkennung von Flugzeugbauteilen mittels einer Drohne bekannt, wobei die Drohne ein Flugzeug abfliegt und einzelne Bauteile des Flugzeugs mittels darauf angebrachten RFID tags identifiziert. Über eine Basisstation werden die gelesenen Daten mit Referenzdaten abgeglichen und ein Report generiert.

Aus der US 2014/361074 A1 ist ein Verfahren zur Verwaltung von Bauteilinformationen während eines Lebenszyklus von Bauteilen bekannt. Die Informationen können beginnend mit der Herstellung eines Bauteils und während des Betriebs des Bauteil gesammelt werden.

Aus der US 2015/269787 A1 ist ein Verfahren zur Wartung eines Fahrzeugs bekannt, bei dem Identifikationsinformationen für Teile des Fahrzeugs von einem RFID tag gelesen werden können.

Aus der US 2010/308166 A1 ist eine Sitzgruppe für ein Flugzeug bekannt, die einen Sitzbelegungssensor enthält, welcher mit einer Steuereinheit des Flugzeugs kommunizieren kann.

Außerdem ist es aus dem Stand der Technik bekannt, dass Flugzeuge eine Vielzahl von Vorrichtungen aufweisen können, die jeweils mindestens ein kommunikationsfähiges Bauteil aufweisen. Das jeweilige Bauteil kann über eine Funkschnittstelle oder eine drahtgebundene Schnittstelle zur Kommunikation mit einem Server ausgebildet sein. Moderne Flugzeuge können eine Vielzahl der Vorrichtungen mit jeweils mindestens einem kommunikationsfähigen Bauteil aufweisen. Die kommunikationsfähigen Bauteile müssen deshalb eindeutig von dem Server identifizierbar und ansprechbar sein, um eine fehlerfreie Kommunikation mit jedem der Bauteile zu erlauben. Bildet beispielsweise ein Sitz im Passagierbereich des Flugzeugs eine Vorrichtung, wobei ein Sitzbelegungssensor das kommunikationsfähige Bauteil dieser Vorrichtung bildet, so ist es zur Feststellung der tatsächlichen Belegung der Sitzplätze im Flugzeug notwendig, dass bei einer Vielzahl der Sitze im Passagierbereich der jeweils zugehörige Sitzbelegungssensor eindeutig mit dem Server kommunizieren kann. Die Sitzbelegungssensoren der Vielzahl der Sitze im Flugzeug sind jedoch vom gleichen Typ. Mit anderen Worten sind sie zumeist baugleich.

Der Erfindung liegt die Aufgabe zugrunde, ein Verfahren bereitzustellen, mit dem feststellbar ist, ob mit einer Vielzahl von kommunikationsfähigen Bauteilen in einem Flugzeug eindeutig kommuniziert werden kann.

Gelöst wird die Aufgabe der Erfindung durch ein Verfahren mit den Merkmalen des Anspruchs 1. Vorgesehen ist also ein Verfahren zum Feststellen, ob mit einer Vielzahl von kommunikationsfähigen Bauteilen in einem Flugzeug eindeutig kommuniziert werden kann, das zumindest die Schritte T1), E1), S1), I1), V1) und N1) aufweist. Die genannten Schritte werden vorzugsweise in der wiedergegebenen Reihenfolge ausgeführt. Grundsätzlich ist es jedoch möglich, dass weitere Schritte oder
Teilschritte zwischen zwei der genannten Schritte ausgeführt werden. Gemäß Schritt T1) des Verfahrens erfolgt ein Übertragen eines Konfigurationssignals von einem Endgerät an ein Host-System, wobei das Konfigurationssignal mindestens einen Hauptdatensatz repräsentiert, und wobei jeder Hauptdatensatz genau eine zugehörige, eindeutige Vorrichtungskennung einer jeweiligen Vorrichtung eines Flugzeugs repräsentiert und für diese jeweilige Vorrichtung mindestens einen Hilfsdatensatz umfasst, der jeweils genau einem Bauteil der jeweiligen Vorrichtung eindeutig zugeordnet ist. Außerdem ist es vorgesehen, dass jeder Hilfsdatensatz eine zugehörige, eindeutige Teilnehmerkennung des jeweiligen Bauteils, eine nicht-eindeutige Teilekennung des jeweiligen Bauteils und eine Initialschlüsselkennung umfasst, wobei von dem Host-System ein Referenzdatensatz gespeichert ist, der eine Vielzahl von Vorrichtungskennungen und für jede Vorrichtungskennung mindestens eine zugeordnete, nicht-eindeutige Referenzteilekennung umfasst. Gemäß Schritt E1) erfolgt ein Empfang des Konfigurationssignals mittels des Host-Systems. Gemäß Schritt S1) erfolgt ein Speichern des mindestens einen, mittels des Konfigurationssignals empfangenen Hauptdatensatzes von dem Host-System. Gemäß Schritt E1) erfolgt ein Identifizieren der Vorrichtungskennung eines jeden Hauptdatensatzes, der mittels des Konfigurationssignals empfangen wird, in dem Referenzdatensatz mittels des Host-Systems. Schritt e1) umfasst außerdem ein Bestimmen der mindestens einen zu der identifizierten Vorrichtungskennung zugehörigen, nicht-eindeutigen Referenzteilekennung in dem Referenzdatensatz mittels des Host-Systems. Gemäß Schritt V1) erfolgt ein Vergleichen der mindestens einen Teilekennung, die von dem mindestens einen Hilfsdatensatz eines jeweiligen Hauptdatensatzes umfasst ist, mit der mindestens einen Referenzteilekennung, die für die jeweilige Vorrichtungskennung des jeweiligen Hauptdatensatzes in Schritt I1) identifiziert wurde. Vorzugsweise wird Schritt V1) für jeden Hauptdatensatz ausgeführt. Schließlich erfolgt gemäß Schritt N1) ein Erzeugen und Versenden eines Reportsignals mittels des Host-Systems, so dass das Reportsignal ein Ergebnis des Vergleichs aus Schritt V1) repräsentiert, wobei das Reportsignal ablesbar ist, um festzustellen, ob die im Flugzeug (10) verbauten Vorrichtungen (8), die jeweils kommunikationsfähige Bauteile aufweisen, richtig verbaut sind.

Ein Flugzeug kann eine Vielzahl von Vorrichtungen umfassen. Eine Vorrichtung kann beispielsweise ein Sitz aus dem Passagierbereich des Flugzeugs oder ein Schrank aus der Küche des Flugzeugs sein. Eine weitere, mögliche Vorrichtung des Flugzeugs ist beispielsweise eine Baugruppe aus dem Toilettenbereich des Flugzeugs. Andere Objekte im Flugzeug können jedoch auch eine Vorrichtung des Flugzeugs sein. Von besonderem Interesse sind dabei die Vorrichtungen des Flugzeugs, die jeweils mindestens ein Bauteil aufweisen, das als kommunikationsfähiges Bauteil ausgebildet ist. Wenn im Folgenden also auf eine Vorrichtung des Flugzeugs Bezug genommen wird, ist damit eine Vorrichtung mit mindestens einem Bauteil gemeint, das jeweils zur Funk-Kommunikation oder kabelgebundenen Kommunikation ausgebildet ist. Bevorzugt bildet jedes Bauteil einen Teil der jeweils zugeordneten Vorrichtung. Dies ist insbesondere dann gegeben, wenn die Vorrichtung das mindestens eine zugehörige Bauteil sowie noch weitere Elemente umfasst. Jedes dieser Bauteile der Vorrichtung kann somit als ein Kommunikationsbauteil ausgebildet sein und/oder eine Einheit umfassen, die für die Kommunikation, insbesondere die Funk-Kommunikation oder kabelgebundenen Kommunikation, ausgebildet ist. **In** einer beispielhaften Ausgestaltung kann die Vorrichtung von einem zugehörigen Bauteil vollständig gebildet sein. In dieser Ausgestaltung wird dennoch von der Vorrichtung und dem Bauteil gesprochen. In der Praxis kann es vorkommen, dass mehrere Vorrichtungen jeweils baugleiche, kommunikationsfähige Bauteile umfassen. So kann ein Flugzeug beispielsweise mehrere Sitze aufweisen, die jeweils eine Vorrichtung bilden und jeweils ein kommunikationsfähiges Bauteil, wie beispielsweise einen kommunikationsfähigen Sitzbelegungssensor, aufweisen. Der Sitzbelegungssensor kann die Belegung des Sitzes sensorisch erfassen und außerdem ein Sensorsignal übertragen, das den Belegungszustand des jeweiligen Sitzes repräsentiert. Die Sitzbelegungssensoren können für die Sitze des Flugzeugs baugleich ausgebildet sein. Die technischen Merkmale, die Bauform und/oder der Typ jedes Sitzbelegungssensors kann durch die gleiche Teilekennung repräsentiert sein. Für jedes kommunikationsfähige Bauteil einer Vorrichtung des Flugzeugs ist deshalb eine Teilekennung des jeweiligen Bauteils vorgesehen. Diese Teilekennung ist nicht eindeutig für das jeweilige Bauteil, da eine Mehrzahl von baugleichen Bauteilen die gleiche Teilekennung aufweisen und/oder tragen können. Es ist deshalb vorgesehen, dass für jedes Bauteil zustätzlich eine zugehörige und eindeutige Teilnehmerkennung vorgesehen ist. Die Teilnehmerkennung kann beispielsweise eine eindeutige Seriennummer, eine eindeutige MAC-Adresse oder eine andere eindeutige Kennung sein, die eindeutig dem jeweiligen Bauteil zugeordnet ist. Über die Teilnehmerkennung ist jedes Bauteil eindeutig identifizierbar. Für jedes Bauteil ist außerdem eine Initialschlüsselkennung vorgesehen. Die Initialschlüsselkennung kann eindeutig oder nicht-eindeutig sein. Vorzugsweise ist die Initialschlüsselkennung nicht eindeutig, so dass alle oder eine Mehrzahl der Bauteile die gleiche, nicht-eindeutige Initialschlüsselkennung zugeordnet ist.

Bei der Herstellung eines Flugzeugs wird oftmals eine Vielzahl von Vorrichtungen verbaut, die jeweils mindestens ein kommunikationsfähiges Bauteil umfassen. Bei der Herstellung wird deshalb eine der jeweiligen Vorrichtung zugehörige, eindeutige Vorrichtungskennung erfasst. Die Vorrichtungskennung kann als FIN bezeichnet und/oder abgekürzt sein. Außerdem wird für jedes kommunikationsfähige Bauteil, das einen Teil der Vorrichtung bildet, die jeweils zugehörige, eindeutige Teilnehmerkennung, die zugehörige und nicht-eindeutige Teilekennung sowie die zugehörige Initialschlüsselkennung erfasst. Das Erfassen der zuvor genannten Kennungen, also der Vorrichtungskennung, der Teilnehmerkennung, der Teilekennung sowie der Initialschlüsselkennung kann beispielsweise durch optisches Einlesen von Zahlenkolonnen, Barcodes, QR-Codes erfolgen. Das Erfassen kann jedoch auch durch nicht-optische Erfassungsmethoden erfolgen, beispielsweise durch RFID-Tags, in denen die jeweilige Kennung der Vorrichtung bzw. des Bauteils gespeichert ist. Weist eine Vorrichtung mehrere Bauteile auf, können für jedes Bauteil mindestens ein Barcode, QR-Code oder RFID-Tag an dem jeweiligen Bauteil befestigt sein, um das zuvor erläuterte Erfassen zu ermöglichen. Zur Erfassung können spezielle Erfassungsgeräte eingesetzt werden. Es ist jedoch auch möglich, dass die Erfassung mittels eines speziell konfigurierten Mobiltelefons oder Tablets erfolgt, das eine Kamera aufweist. Es ist aber auch möglich, dass auf jeder Vorrichtung, das mindestens ein kommunikationsfähiges Bauteil umfasst, ein Aufkleber mit der Vorrichtungskennung und auf jedem der kommunikationsfähigen Bauteile ein weiterer Aufkleber angeordnet ist, der die Teilnehmerkennung, die nicht-eindeutige Teilekennung und die Initialschlüsselkennung umfasst. Der Aufkleber kann die Kennungen als optisch erfassbare Kennungen darstellen oder einen RFID-Tag umfassen. Die Aufkleber sind jedoch nur rein beispielhaft genannt. Die jeweiligen Kennungen können auch durch andere Mittel an der Vorrichtung bzw. dem jeweiligen Bauteil zugänglich gemacht sein. Sofern die Kennungen als optisch erfassbare Kennungen auf dem jeweiligen Aufkleber dargestellt sind, können die Aufkleber abgezogen werden und in einer Zuordnung auf einem Blatt Papier wieder aufgeklebt werden, so dass das Blatt Papier im Anschluss eingescannt werden kann, um die Kennung sowie die Zuordnung der entsprechenden Kennungen zu erfassen.

Die Erfassung der Kennungen über vorkonfigurierte, mobile Geräte, wie beispielsweise einem speziell konfigurierten Mobiltelefon, oder die Erfassung der Kennungen über ein nachträgliches Einscannen von Papier, verursacht im Ergebnis ein Konfigurationssignal von einem Endgerät an ein Host-System, wobei das Konfigurationssignal mindestens einen Hauptdatensatz repräsentiert. Das Endgerät kann beispielsweise das speziell konfigurierte Mobiltelefon oder ein Computersystem mit einem Papierscanner sein. Das Mobiltelefon und/oder das Computersystem können jeweils zur Übertragung des Konfigurationssignals ausgebildet sein. Der über das Konfigurationssignal an das Host-System übertragene Hauptdatensatz repräsentiert für jede Vorrichtung des Flugzeugs genau eine zugehörige, eindeutige Vorrichtungskennung sowie für diese jeweilige Vorrichtung mindestens einen Hilfsdatensatz, der jeweils genau einem Bauteil der jeweiligen Vorrichtung eindeutig zugeordnet ist. Der Hauptdatensatz kann beispielsweise mindestens zehn Vorrichtungskennungen repräsentieren, die jeweils genau einer Vorrichtung des Flugzeugs zugeordnet sind. Dies kann beispielsweise dann der Fall sein, wenn das Flugzeug eine Vielzahl von Sitzen mit Sitzbelegungssensoren aufweist. In diesem Fall kann der Hauptdatensatz für zehn Sitze des Flugzeugs jeweils genau eine zugehörige, eindeutige Vorrichtungskennung repräsentieren. Jeder der Sitze kann beispielsweise als ein kommunikationsfähiges Bauteil den Sitzbelegungssensor aufweisen. Es ist deshalb auch vorgesehen, dass jeder Hauptdatensatz zu jeder Vorrichtungskennung mindestens einen Hilfsdatensatz umfasst. Somit ist jeder Vorrichtung mindestens ein Hilfsdatensatz, vorzugsweise mehrere Hilfsdatensätze zugeordnet. Indem jeder Vorrichtung außerdem genau eine Vorrichtungskennung eindeutig zugeordnet ist, besteht auch eine eindeutige Zuordnung zwischen den Vorrichtungskennungen und dem einen oder mehreren Hilfsdatensätzen. Die Anzahl der Hilfsdatensätze, die einer Vorrichtung zugeordnet sind, entspricht der Anzahl der kommunikationsfähigen Bauteile der jeweiligen Vorrichtung. Jeder Hilfsdatensatz ist deshalb jeweils genau einem kommunikationsfähigen Bauteil der jeweiligen Vorrichtung eindeutig zugeordnet. Weist ein Sitz neben dem Sitzbelegungssensor einen noch weiteren Sensor oder weiteres Objekt als ein kommunikationsfähiges Bauteil auf, so können dem jeweiligen Sitz zwei Hilfsdatensätze zugeordnet sein, die jeweils genau dem entsprechenden Sensor bzw. Objekt des Sitzes eindeutig zugeordnet sind. Einer der Hilfsdatensätze kann deshalb dem Sitzbelegungssensor und der andere Hilfsdatensatz dem weiteren Sensor bzw. Objekt des gleichen Sitzes eindeutig zugeordnet sein. Jeder Hilfsdatensatz umfasst eine zugehörige, eindeutige Teilnehmerkennung. Diese eindeutige Teilnehmerkennung kann auch als Identifikationsteilnehmerkennung bezeichnet und so verstanden sein. Über die eindeutige Teilnehmerkennung kann das jeweils zugehörige Bauteil also eindeutig identifiziert werden. Jeder Hilfsdatensatz, der genau einem kommunikationsfähigen Bauteil einer Vorrichtung zugeordnet ist, umfasst außerdem eine nicht-eindeutige Teilekennung des jeweiligen Bauteils und eine Initialschlüsselkennung. Die nicht-eindeutige Teilekennung kann über den Typ des jeweiligen Bauteils, die Kategorie des jeweiligen Bauteils oder eine Bauteilgruppe des jeweiligen Bauteils Aufschluss geben. Die Initialschlüsselkennung kann beispielsweise ein Zertifikat, einen digitalen Schlüssel oder einen Zugangsschlüssel für eine verschlüsselte Kommunikation, insbesondere verschlüsselte Funk-Kommunikation, sein. Mittels der Initialschlüsselkennung kann vorzugsweise eine verschlüsselte Kommunikationsverbindung zu dem Host-System hergestellt werden.

Bei einer Herstellung eines Flugzeugs ist vorab bekannt, welche Vorrichtungen und welche zugehörigen, kommunikationsfähigen Bauteile für die Vorrichtungen verwendet werden. Für die Vorrichtungen ist deshalb jeweils eine zugehörige, eindeutige Vorrichtungskennung und für jedes Bauteil jeder Vorrichtungen ist mindestens eine zugeordnete, nicht-eindeutige Referenzteilekennung bekannt. Aufgrund dieser bekannten Kennungen ist es möglich, dass von dem Host-System ein Referenzdatensatz gespeichert ist. Der Referenzdatensatz umfasst eine Vielzahl von Vorrichtungskennungen. Somit kann für jede Vorrichtung, die im Flugzeug zu verbauen ist, eine jeweils zugehörige Vorrichtungskennung von dem Referenzdatensatz gespeichert sein. Der Referenzdatensatz umfasst außerdem für jede Vorrichtungskennung mindestens eine zugeordnete, nicht-eindeutige Referenzteilekennung. Die Referenzteilekennung kann ein Sollwert für die Teilekennung sein. Identifiziert eine Vorrichtungskennung aus dem Referenzdatensatz beispielsweise einen Sitz für ein Flugzeug, so kann die der jeweiligen Vorrichtungskennung zugeordnete, nicht-eindeutige Referenzteilekennung beispielsweise den Soll-Typ des Sitzbelegungssensor des Sitzes repräsentieren. Die nicht-eindeutige Referenzteilekennung fordert nicht, dass ein vorab genau identifizierter Sitzbelegungssensor für den jeweiligen Sitz verwendet wird. Jedoch kann die nicht-eindeutige Referenzteilekennung bestimmen, dass der für den Sitz zu verwendende Sitzbelegungssensor von einem bestimmten Typ sein soll. Soll der Sitz für das Flugzeug mehrere, beispielsweise zwei elektrische kommunikationsfähige Sensoren aufweisen, so kann der Vorrichtungskennung aus dem Referenzdatensatz für diesen Sitz nicht nur eine sondern beispielsweise zwei nicht-eindeutige Referenzteilekennungen zugeordnet sein. Sollen die Sensoren von einem unterschiedlichen Typ sein, so werden sich die Referenzteilekennungen ebenfalls unterscheiden. Aus dem Referenzdatensatz, der von dem Host-System gespeichert ist, kann also für jede Vorrichtungskennung einer für das Flugzeug zu verbauenden Vorrichtung die mindestens eine zugeordnete, nicht-eindeutige Referenzteilekennung für das jeweils zugehörige Bauteil der zu verbauenden Vorrichtung entnommen werden. Hierzu kann das Host-System entsprechend angepasst sein.

Jeder Hauptdatensatz repräsentiert vorzugsweise eine von der Vorrichtung bereitgestellte und erfasste, eindeutige Vorrichtungskennung. Jeder Hauptdatensatz wird durch Erfassen der tatsächlichen Kennungen an der jeweiligen Vorrichtung und dem mindestens einen zugehörigen Bauteil erzeugt. Jeder Hauptdatensatz gibt also die für die jeweilige Vorrichtung tatsächlich zugeordnete, eindeutige Vorrichtungskennung an. Für jedes kommunikationsfähige Bauteil der Vorrichtung umfasst der Hauptdatensatz außerdem die Kennungen des Hilfsdatensatzes für das jeweilige Bauteil, wobei die Kennungen des Hilfsdatensatzes vorzugsweise ebenfalls an den Bauteilen der Vorrichtung oder an der Vorrichtung selbst sensorisch erfasst sind. Es handelt sich also um die tatsächlichen Kennungen für das jeweilige Bauteil der tatsächlichen Vorrichtung.

Durch das Empfangen des Konfigurationssignals wird der mindestens eine Hauptdatensatz an das Host-System übertragen. Der mindestens eine Hauptdatensatz wird außerdem vom Host-System gespeichert. Dem Host-System liegen somit der Referenzdatensatz und mindestens ein Hauptdatensatz vor.

Für jede Vorrichtung mit mindestens einem kommunikationsfähigen Bauteil des Flugzeugs gibt es also mindestens einen Hauptdatensatz, der von dem Host-System gespeichert ist. In dem Referenzdatensatz ist für jede Vorrichtung des Flugzeugs außerdem eine Vorrichtungskennung und mindestens eine Referenzteilekennung bereitgestellt.

In Schritt I1) identifiziert das Host-System die Vorrichtungskennung eines jeden Hauptdatensatzes in dem Referenzdatensatz, so dass von dem Host-System dabei außerdem die mindestens eine zugehörige, nicht-eindeutige Referenzteilekennung in dem Referenzdatensatz durch Auslesen bestimmt wird. Dadurch wird also festgestellt, welche mindestens eine Referenzteilekennung für eine Vorrichtungskennung des Hauptdatensatzes bestehen sollte. Im Anschluss folgt in Schritt V1) ein Vergleich zwischen der mindestens einen identifizierten Referenzteilekennung und der mindestens einen tatsächlichen Teilekennung, die von dem mindestens einen Hilfsdatensatz des jeweiligen Hauptdatensatzes umfasst ist. Vorzugsweise wird Schritt V1) für jeden Hauptdatensatz ausgeführt. Der Vergleich zwischen den Referenzteilekennungen und den tatsächlichen Teilekennungen dient zur Überprüfung. Der Vergleich kann beispielsweise ergeben, dass die Referenzteilekennung, die einer Vorrichtungskennung zugeordnet ist, der tatsächlichen Teilekennung entspricht, die der gleichen Vorrichtungskennung zugeordnet ist. Sind für die entsprechende Vorrichtung mehrere kommunikationsfähige Bauteil vorgesehen, kann der Vergleich auch zwischen der Mehrzahl der Referenzteilekennungen und den tatsächlichen Teilekennungen erfolgen. Gibt die Vorrichtungskennung beispielsweise einen Sitz für ein Flugzeug an, so können die zugehörigen Referenzteilekennungen beispielsweise zwei unterschiedliche Typen von Sensoren für den Sitz bestimmen. Sind entsprechende Typen von Sensoren bei der Herstellung des Flugzeugs an einem Sitz verbaut, der die Vorrichtungskennung trägt, so sollten die Teilekennungen für die Sensoren des Sitzes den Referenzteilekennungen entsprechen. Der Vergleich ergibt also, ob sich die Referenzteilekennungen und die tatsächlichen Teilekennungen entsprechen und damit die richtigen Typen von Sensoren in dem jeweiligen Sitz verbaut sind. Der Vergleich kann im Ergebnis eine Übereinstimmung repräsentieren. Sind die einer Vorrichtungskennung zugeordneten, tatsächlichen Teilekennungen anders als die der gleichen Vorrichtungskennung zugeordneten Referenzteilekennungen, so entsteht ein Unterschied zwischen den tatsächlichen Teilekennungen und den Referenzteilekennungen. Der Vergleich in Schritt V1) kann in diesem Fall im Ergebnis einen Unterschied bzw. eine Nicht-Übereinstimmung in den Referenzteilekennungen und Teilekennungen repräsentieren.

Oftmals ist es bereits bei der Herstellung des Flugzeugs wünschenswert zu wissen, ob die richtigen Bauteile in einer Vorrichtung eines Flugzeugs verbaut sind. Deshalb besteht auch der Bedarf, dass eine Übereinstimmung oder eine Nicht-Übereinstimmung als Ergebnis des Vergleichs aus Schritt V1) bereitgestellt wird und/oder an eine übergeordnete Einheit übertragen wird. Das Verfahren sieht deshalb in Schritt N1) das Erzeugen und Versenden eines Reportsignals mittels des Host-Systems vor, so dass das Reportsignal das Ergebnis des Vergleichs aus Schritt V1) repräsentiert. Anhand des Reportsignals kann also nach der Herstellung des Flugzeugs oder selbst während der Herstellung des Flugzeugs abgelesen werden, ob die in dem Flugzeug verbauten Vorrichtungen, die jeweils kommunikationsfähige Bauteile aufweisen, richtig verbaut sind. Bei Fehlern kann eine schnelle und sichere Ausbesserung mit den richtigen kommunikationsfähigen Bauteilen erfolgen.

Nachdem für alle für alle Hauptdatensätze der jeweilige Vergleich ausgeführt ist, kann mittels des Host-Systems außerdem festgestellt werden, ob einer der Vorrichtungskennungen und/oder einer der Referenzkennungen nicht für einen der Vergleiche verwendet wurde. Sofern zumindest eine der Kennungen des Referenzdatensatzes nicht für einen der Vergleiche verwendet wurde, kann das Reportsignal außerdem die Information umfassen, dass zumindest einer der Kennungen der Vorrichtungen und/oder zumindest eine der Kennungen der Bauteile nicht erfasst wurde.

Auch wenn die vorangegangenen Erläuterungen oftmals anhand eines Beispiels im Zusammenhang mit einem Sitz und zugehörigen Sensoren dargestellt worden sind, gelten die vorangegangenen Erläuterungen in analoger Weise für beliebige Vorrichtungen des Flugzeugs, wenn jede Vorrichtung mindestens ein kommunikationsfähiges Bauteil aufweist. Die kommunikationsfähigen Bauteile sind außerdem nicht auf Sensoren beschränkt. Es können auch andere elektronische und kommunikationsfähige Bauteile in einer Vorrichtung vorgesehen sein, die nicht zwingend als Sensor ausgebildet sind. Jedes dieser Bauteile weist vorzugsweise eine Kommunikationseinheit auf, um eine Kommunikationsverbindung zu dem Host-System oder einem Kommunikationssystem des Flugzeugs herzustellen. Dabei ist es bevorzugt vorgesehen, dass jede Kommunikationseinheit als eine Funkeinheit ausgebildet ist, um eine Funkverbindung zu dem Host-System und/oder dem Kommunikationssystem des Flugzeugs herzustellen.

Das zuvor erläuterte Verfahren findet bevorzugt bei der Herstellung eines Flugzeugs Anwendung. Es ist jedoch auch möglich, dass das Verfahren beispielsweise bei einer Reparatur oder einem Austausch einer Vorrichtung des Flugzeugs angewendet wird. Ist beispielsweise eine Vorrichtung eines Flugzeugs defekt, wobei die Vorrichtung mindestens ein kommunikationsfähiges Bauteil umfasst, so kann das Verfahren in Schritt T1) die Übertragung des Kommunikationssignals an das Host-System umfassen, wobei das Kommunikationssystem einen Hauptdatensatz, und vorzugsweise genau einen Hauptdatensatz, umfasst. Dieser Hauptdatensatz kann eine eindeutige Vorrichtungskennung für die neu installierte Vorrichtung des Flugzeugs repräsentieren und außerdem für jedes kommunikationsfähige Bauteil dieser neuen Vorrichtung jeweils einen Hilfsdatensatz umfassen. Der im Host-System gespeicherte Referenzdatensatz kann eine Vorrichtungskennung für diese neu verbaute Vorrichtung umfassen. Außerdem kann der Referenzdatensatz für jedes kommunikationsfähige Bauteil der neu verbauten Vorrichtung jeweils eine nicht-eindeutige Referenzteilekennung umfassen. Die Schritte I1) bis N1) können in analoger Weise ausgeführt werden, wie es zuvor erläutert worden ist. Bei einer Reparatur eines Flugzeugs, bei der ein Austausch der Vorrichtung stattfindet, kann das Verfahren deshalb in analoger Weise angewendet werden. Das Verfahren eignet sich deshalb sowohl zur Anwendung bei der Herstellung eines Flugzeugs als auch bei der Reparatur oder Wartung eines Flugzeugs.

Eine vorteilhafte Ausgestaltung des Verfahrens zeichnet sich dadurch aus, dass in Schritt V1) mittels des Host-Systems überprüft wird, ob die miteinander zu vergleichenden Teilekennungen und Referenzteilekennungen übereinstimmen. Außerdem ist es bevorzugt vorgesehen, dass das Reportsignal in Schritt N1) mittels des Host-Systems derart erzeugt wird, dass das Ergebnis eine positive Übereinstimmung repräsentiert, wenn die Überprüfung aus Schritt V1) keine Unterschiede ergibt, und anderenfalls die voneinander abweichenden Kennungen durch das Reportsignal indiziert. Wenn die Überprüfung aus Schritt V1) beispielsweise keine Unterschiede zwischen den zu vergleichenden Teilekennungen und Referenzteilekennungen ergibt, kann das Reportsignal als eine positive Übereinstimmung beispielsweise ein "ok" oder einen vorbestimmten Code repräsentieren, der die positive Übereinstimmung angibt. Anderenfalls ist es bevorzugt vorgesehen, dass das Reportsignal die voneinander abweichenden Kennungen indiziert, beispielsweise in dem die abweichende Teilekennung durch einen Buchstaben- und/oder Zahlencode angegeben ist. Die Indizierung der abweichenden Teilekennung kann aber auch durch den Klartext der jeweiligen, abweichenden Teilekennung erfolgen. Aus dem Reportsignal kann somit besonders einfach abgelesen werden, ob die richtigen, kommunikationsfähigen Bauteile für die Vorrichtungen des Flugzeugs verbaut worden sind, oder ob es Fehler bei der Installation der kommunikationsfähigen Bauteile für die Vorrichtungen gab. Ist dies der Fall, kann aus dem Reportsignal die entsprechende Teilekennung für das jeweilige Bauteil abgelesen werden, so dass eine einfache Korrektur durch den Austausch des jeweiligen, kommunikativen Bauteils möglich ist. Außerdem kann das Reportsignal die Vorrichtungskennung derjenigen Vorrichtung indizierten, die das Bauteil mit der indizierten Teilnehmerkennung umfasst. Dies kann das Auffinden der jeweiligen Vorrichtung mit dem fehlerhaft installierten Bauteil in der Praxis erleichtern.

Eine vorteilhafte Ausgestaltung des Verfahrens zeichnet sich dadurch aus, dass das Konfigurationssignal mehrere Hauptdatensätze repräsentiert. Dies ist beispielsweise dann der Fall, wenn mehrere Vorrichtungen in dem Flugzeug verbaut werden und das Konfigurationssignal im Anschluss, nachdem die Vorrichtungen im Flugzeug verbaut werden, von einem Endgerät an das Host-System übertragen werden. Das Endgerät kann dabei von einem Computersystem mit einem Scanner gebildet sein, der die Vorrichtungskennungen und die Kennungen der jeweiligen Hilfsdatensätze erfasst und hieraus mehrere Hauptdatensätze erzeugt, die mittels des Konfigurationssignals an das Host-System übertragen werden. In analoger Weise ist dies jedoch auch bei einem mobilen Endgerät möglich, das beispielsweise von einem speziell konfigurierten Mobiltelefon mit einer Kamera gebildet ist. Mit diesem mobilen Endgerät können die mehreren Vorrichtungskennungen und die Kennungen der mehreren Hilfsdatensätze bei der Installation der Mehrzahl der Vorrichtungen im Flugzeug erfasst werden. Anschließend, nachdem das mobile Endgerät eine Kommunikationsverbindung zu dem Host-System hergestellt hat, kann die Übertragung des Konfigurationssignals starten, um die mehreren Hauptdatensätze an das Host-System zu übertragen. Das Host-System kann ein stationäres Host-System sein. Das Host-System kann getrennt von dem Flugzeug ausgebildet sein. Es ist jedoch auch möglich, dass das Host-System von dem Flugzeug umfasst ist oder das ein Teil des Flugzeugs dem Host-System zugeordnet ist.

Eine weitere vorteilhafte Ausgestaltung des Verfahrens zeichnet sich dadurch aus, dass das Endgerät ein stationäres Endgerät mit einem Papierscanner ist. Aufkleber auf den Vorrichtungen und den kommunikationsfähigen Bauteilen können während der Installation der Vorrichtungen im Flugzeug abgezogen werden und sodann in geordneter, vorbestimmter Weise auf einem Blatt Papier aufgeklebt werden. Anschließend kann das Einscannen des Blatt Papiers mittels des Papierscanners erfolgen. Dadurch können mittels des stationären Endgeräts mehrere Hauptdatensätze erzeugt werden. Das Endgerät ist außerdem zur Erzeugung und Übertragung des Konfigurationssignals an das Host-System ausgebildet, wobei das Konfigurationssignal die mehreren Hauptdatensätze repräsentiert.

Eine weitere vorteilhafte Ausgestaltung des Verfahrens zeichnet sich dadurch aus, dass das Endgerät ein mobiles Endgerät ist. Das mobile Endgerät kann beispielsweise von einem Mobiltelefon mit einer Kamera oder einem Tablet mit einer Kamera gebildet sein. Es ist jedoch auch möglich, dass andere mobile Endgeräte mit einer Kamera als mobile Endgeräte eingesetzt werden, die zur Herstellung einer Kommunikationsverbindung zu dem Host-System ausgebildet sind. Jedes mobile Endgerät kann beispielsweise zur optischen Erfassung der Vorrichtungserkennungen und der Kennungen der Bauteile ausgebildet sein. Außerdem kann jedes mobile Endgerät zur Erzeugung des Hauptdatensatzes und zur Übertragung des Hauptdatensatzes mittels des Konfigurationssignals ausgebildet sein. Die Hauptdatensätze können nach der Installation von jeder Vorrichtung über ein jeweiliges Konfigurationssignal an das Host-System übertragen werden. Das mobile Endgerät kann jedoch auch dazu ausgebildet sein, während der Installation von mehreren Vorrichtungen die entsprechende Anzahl von Hauptdatensätzen zu speichern und nach dem Abschluss der Installation der Mehrzahl der Vorrichtungen die Übertragung des Konfigurationssignals zu starten, dass die mehreren Hauptdatensätze repräsentiert.

Eine weitere vorteilhafte Ausgestaltung des Verfahrens zeichnet sich dadurch aus, dass das mobile Endgerät eine Kamera aufweist, wobei das Verfahren außerdem die folgenden Schritte K1), K2) und K3) aufweist, die vor Schritt T1) des Verfahrens ausgeführt werden. Die Schritte K1), K2) und K3) können in der angegebenen Reihenfolge ausgeführt werden. Gemäß Schritt K1) erfolgt ein direktes oder indirektes, optisches Erfassen von einer Vorrichtungskennung auf einer Vorrichtung mittels des Endgeräts. Gemäß Schritt K2) erfolgt ein direktes oder indirektes, optisches Erfassen von einer Teilnehmerkennung, einer nicht-eindeutigen und einer Initialschlüsselkennung auf jedem Bauteil der Vorrichtung aus Schritt K1) mittels des Endgeräts. Gemäß Schritt K3) erfolgt ein Erzeugen des Hauptdatensatzes für jede Vorrichtung aus der in Schritt K1) erfassten, zugehörigen Vorrichtungskennung und des mindestens einen zugehörigen Hilfsdatensatzes mit den in Schritt K2) erfassten Kennungen mittels des Endgeräts. Die Vorrichtungskennung einer Vorrichtung des Flugzeugs und die Kennungen der Bauteile dieser Vorrichtung können optisch mittels des Endgeräts erfasst werden. Die Kennungen können beispielsweise durch Barcodes, Strichcodes oder im Klartext auf entsprechenden Aufklebern an der Vorrichtung und/oder den Bauteilen optisch erfasst werden. Das Endgerät kann eine Kamera oder ein anderes optisches Lesegerät aufweisen, um die Kennungen der Vorrichtungen und der Bauteile zu erfassen. Sind die Vorrichtungskennung für die Vorrichtung und jede der Kennungen des mindestens einen Bauteils optisch mittels des Endgeräts erfasst, erzeugt das Endgerät in Schritt K3) den Hauptdatensatz für die jeweilige Vorrichtung. Dieser Hauptdatensatz umfasst die eindeutige Vorrichtungskennung für die jeweilige Vorrichtung und für jedes kommunikationsfähige Bauteil der Vorrichtung jeweils einen entsprechenden Hilfsdatensatz, der jeweils eine eindeutige Teilnehmerkennung, eine nicht-eindeutige Teilekennung und eine Initialschlüsselkennung umfasst. Das Endgerät ist außerdem ausgebildet, um das Konfigurationssignal, das den mindestens einen in Schritt K3) erzeugten Hauptdatensatz umfasst, an das Host-System zu übertragen. In der Praxis kann das mobile Endgerät beispielsweise von einem speziell konfigurierten Mobiltelefon mit einer Kamera gebildet sein. Bei der Herstellung des Flugzeugs können Personen das mobile Endgerät verwenden, um mittels der Kamera die Kennungen der Vorrichtungen und der Bauteile optisch zu erfassen. Auf diese Weise kann eine eindeutige, digitale Zuordnung über die Kennungen von den kommunikationsfähigen Bauteilen zu einer Vorrichtung im jeweiligen Hauptdatensatz erzeugt werden.

Eine weitere vorteilhafte Ausgestaltung des Verfahrens zeichnet sich dadurch aus, dass das mobile Endgerät einen Nahfeld-Leser aufweist, wobei das Verfahren außerdem die folgenden Schritte K1), K2) und K3) aufweist, die vor Schritt T1) ausgeführt werden. Die Schritte K1), K2) und K3) können in der angegebenen Reihenfolge ausgeführt werden. Gemäß Schritt K1) dieser Ausgestaltung des Verfahrens erfolgt ein direktes oder indirektes, elektromagnetisches Erfassen von einer Vorrichtungskennung auf einer Vorrichtung mittels des Endgeräts. Gemäß Schritt K2) dieser vorteilhaften Ausgestaltung des Verfahrens erfolgt ein direktes oder indirektes, elektromagnetisches Erfassen von einer Teilnehmerkennung, einer nicht-eindeutigen Teilekennung und einer Initialschlüsselkennung auf jedem Bauteil der Vorrichtung aus Schritt K1) mittels des Endgeräts. Gemäß Schritt K3) dieser vorteilhaften Ausgestaltung des Verfahrens erfolgt ein Erzeugen des Hauptdatensatzes für jede Vorrichtung aus der in Schritt K1) erfassten, zugehörigen Vorrichtungskennung und des mindestens einen zugehörigen Hilfsdatensatzes mit den in Schritt K2) erfassten Kennungen mittels des Endgeräts. Für die Schritte K1), K2) und K3) wird auf die vorangegangenen Erläuterungen, bevorzugten Merkmale, Effekte und/oder Vorteile für die entsprechenden Schritte K1) bis K3) der vorangegangenen, vorteilhaften Ausgestaltung des Verfahrens in analoger Weise Bezug genommen. Gemäß der zuletzt genannten, vorteilhaften Ausgestaltung des Verfahrens erfolgt das Erfassen der Kennungen jedoch nicht optisch, sondern mittels eines Nahfeld-Lesers des mobilen Endgeräts. Jede Vorrichtung und jedes zugehörige, kommunikationsfähige Bauteil kann eine elektrische Schaltung, insbesondere einen Aufkleber mit einer solchen elektrischen Schaltung, aufweisen, die zum Zusammenwirken mit dem Nahfeld-Leser ausgebildet ist. Von der elektrischen Schaltung kann mindestens eine Kennung gespeichert sein. Der Nahfeld-Leser ist vorzugsweise als ein sogenannter NFC-Leser (NFC steht für Nahfeldkommunikation) oder als ein RFID-Leser (RFID steht für Radio Frequenz Identifikation). Insbesondere kann der Nahfeld-Leser ausgebildet sein, um durch elektromagnetische Wechselwirkung mit einem NFC-Transponder oder einem RFID-Transponder zu kommunizieren. Der Transponder kann auch als Tag bezeichnet und/oder ausgebildet sein. Somit erfolgt die Erfassung der Kennungen berührungslos durch elektromagnetische Wechselwirkung zwischen dem Nahfeld-Leser und der jeweiligen Schaltung. Jeder der Kennungen der Vorrichtungen und der kommunikationsfähigen Bauteile kann somit durch eine jeweils zugehörige Schaltung gespeichert und durch elektromagnetische Wechselwirkung auslesbar sein. Jede elektrische Schaltung kann von einen NFC- oder RFID-Tag, insbesondere einen elektromagnetisch kommunikativen Aufkleber mit dem NFC- oder RFID-Tag gebildet sein. Die Aufkleber können auch als sogenannte NFC-Tag-Aufkleber ausgebildet sein, die jeweils mindestens eine Kennung speichern und deren Kennung jeweils von dem Nahfeld-Leser des Endgeräts durch berührungslose, elektromagnetische Kommunikation auslesbar ist. Auf jeder Vorrichtung kann ein eindeutig zugehöriger NFC-Tag und auf jedem Bauteil kann ebenfalls ein eindeutig zugehöriger NFC-Tag befestigt, insbesondere als Teil eines jeweiligen Aufklebers aufgeklebt sein.

Eine weitere vorteilhafte Ausgestaltung des Verfahrens zeichnet sich dadurch aus, dass in Schritt T1) in mehreren, aufeinanderfolgenden Zeitfenstern jeweils mindestens ein Hauptdatensatz von dem Endgerät an das Host-System übertragen wird. Die mehreren Hauptdatensätze, die von dem Konfigurationssignal repräsentiert werden, müssen also nicht zwingend als ein zusammenhängender Datenblock mittels des Konfigurationssignals übertragen werden. Vielmehr ist es auch möglich, dass jeder Hauptdatensatz in einem zugehörigen Zeitfenster und somit die mehreren Hauptdatensätze in mehreren, aufeinanderfolgenden Zeitfenstern mittels des Kommunikationssignals von dem Endgerät an das Host-System übertragen werden. So können die Hauptdatensätze beispielsweise jeweils nach dem jeweiligen Erzeugen mit dem mobilen Endgerät an das Host-System geschickt werden. Es ist jedoch auch möglich, dass die Hauptdatensätze für alle Vorrichtungen zunächst erzeugt werden, und im Anschluss ohne zeitliche Unterbrechung zwischen den Zeitfenstern nacheinander mittels des Konfigurationssignals an das Host-System übertragen werden.

Eine vorteilhafte Ausgestaltung für das Verfahren zeichnet sich dadurch aus, dass das Endgerät eine erste Signalschnittstelle und das Host-System eine zweite Signalschnittstelle aufweisen, wobei die Signalschnittstellen zur Übertragung eines Signals ausgebildet sind. Die Übertragung des Signals kann per Funk oder kabelgebunden erfolgen. Somit kann jede der ersten und/oder zweiten Signalschnittstelle als eine Funksignalschnittstelle oder als eine kabelgebundene Signalschnittstelle ausgebildet sein. Das zu übertragende Signal kann beispielsweise das Konfigurationssignal und/oder das Reportsignal sein, das bzw. die zwischen dem Endgerät und dem Host-System übertragen wird bzw. werden.

Eine weitere vorteilhafte Ausgestaltung des Verfahrens zeichnet sich dadurch aus, dass das Endgerät ein Display aufweist und die erste Signalschnittstelle zum Empfang des Reportsignals ausgebildet ist, und wobei das Verfahren außerdem die Schritte R1) und A1) aufweist. Gemäß Schritt R1) erfolgt ein Empfang des Reportsignals mittels der ersten Signalschnittstelle des Endgeräts. Gemäß Schritt A1) erfolgt ein Anzeigen einer Nachricht, die das Ergebnis des Vergleichs aus Schritt V1) optisch repräsentiert, basierend auf dem Reportsignal und mittels des Displays des Endgeräts. Nach dem optischen Erfassen der Kennungen für die Vorrichtungen und die kommunikationsfähigen Bauteile werden die Hauptdatensätze über das Konfigurationssignal an das Host-System übertragen, so dass mittels des Host-Systems die Vorrichtungskennungen in dem Referenzdatensatz identifiziert werden können und die dabei ausgelesenen Referenzteilekennungen mit den tatsächlichen Teilkennungen verglichen werden können. Das von dem Host-System erzeugte Reportsignal gibt vorzugsweise an, ob das Ergebnis des Vergleichs eine positive Übereinstimmung repräsentiert, oder ob die Überprüfung Abweichungen zwischen den Kennungen indiziert. Das entsprechende Reportsignal wird also von dem Host-System an das mobile Endgerät gesendet. Hierzu können die erste und zweite Signalschnittstelle verwendet werden. Das von dem Endgerät empfangene Reportsignal kann deshalb dazu dienen, um die Nachricht auf dem Display des Endgeräts anzuzeigen. Die Nachricht kann dabei angeben, ob das Ergebnis der Überprüfung eine positive Übereinstimmung repräsentiert, oder ob es Unterschiede zwischen den Referenzteilekennungen und den tatsächlichen Teilekennungen gab. Der Benutzer des Endgeräts erhält somit die Informationen darüber, ob die Vorrichtungen mit den zugehörigen, kommunikationsfähigen Bauteilen in der vorbestimmten Weise in dem Flugzeug verbaut worden sind, wie es entsprechend dem Referenzdatensatz vorgesehen ist.

Eine weitere vorteilhafte Ausgestaltung des Verfahrens zeichnet sich dadurch aus, dass die erste Schnittstelle und die zweite Schnittstelle jeweils als Funkschnittstelle ausgebildet sind, wobei das Konfigurationssignal in Schritt T1) als Funk-Konfigurationssignal übertragen wird, und wobei das Reportsignal in Schritt N1) als Funk-Reportsignal versendet wird. Durch die Funkübertragung zwischen der ersten und zweiten Schnittstelle ist es möglich, dass das Endgerät als ein mobiles Endgerät ausgebildet ist. Das mobile Endgerät kann die Hauptdatensätze mittels des Konfigurationssignals jeweils nach dem Erzeugen des jeweiligen Hauptdatensatzes an das Host-System per Funk übertragen. Das Host-System kann so ausgebildet werden, dass die Schritte I1) und V1) für jeden empfangenen Hauptdatensatz einzeln ausgeführt werden, so dass für jeden empfangenen Hauptdatensatz ein entsprechendes Reportsignal zurück an das mobile Endgerät gesendet wird. Dies ist insbesondere bei der Reparatur, Wartung und/oder Herstellung des Flugzeugs von Vorteil, denn auf diese Weise kann unmittelbar vor Ort festgestellt werden, ob die zuletzt installierte Vorrichtung für das Flugzeug korrekt verbaut ist.

Eine weitere vorteilhafte Ausgestaltung des Verfahrens zeichnet sich dadurch aus, dass das Verfahren außerdem die Schritte H1), Z1) und W1) aufweist. Gemäß Schritt H1) erfolgt ein Herstellen einer Funksignalverbindung von einer dritten Funk-Signalschnittstelle eines Bauteils einer Vorrichtung eines Flugzeugs zu der zweiten Funk-Signalschnittstelle des Host-Systems, wobei in einer Speichereinheit des jeweiligen Bauteils die zugehörige, eindeutige Teilnehmerkennung des jeweiligen Bauteils, eine nicht-eindeutige Teilekennung des jeweiligen Bauteils und eine Initialschlüsselkennung gespeichert sind, und wobei die Funksignalverbindung mittels der Initialschlüsselkennung verschlüsselt wird. Gemäß Schritt Z1) erfolgt ein Zuweisen und Übertragen einer neuen Schlüsselkennung von dem Host-System an das Bauteil über die Funksignalverbindung. Gemäß Schritt W1) erfolgt ein Neuherstellen einer neuen, mittels der neuen Schlüsselkennung verschlüsselten Funksignalverbindung von der dritten Funk-Signalschnittstelle des Bauteils zu der zweiten Funksignalschnittstelle des Host-Systems.

Das Ausführen der Schritte H1), Z1) und W1) erfolgt also nach der Installation der Vorrichtung in dem Flugzeug. Zuvor wurde mittels des Endgeräts überprüft, ob die Vorrichtung und die zugehörigen, kommunikationsfähigen Bauteile korrekt verbaut sind. Über die Initialschlüsselkennung kann das jeweilige Bauteil eine Funkverbindung zu dem Host-System herstellen. Die Initialschlüsselkennung ist jedoch nicht eindeutig. Deshalb folgt in Schritt Z1) das Übertragen einer neuen Schlüsselkennung und in Schritt W1) die Neuherstellung einer mittels der neuen, zuletzt empfangenen Schlüsselkennung verschlüsselten Funksignalverbindung von dem jeweiligen Bauteil zu dem Host-System. Die neue Schlüsselkennung ist vorzugsweise eine eindeutige und allein dem jeweiligen Bauteil zugeordnete Schlüsselkennung, so dass die über die neue Schlüsselkennung verschlüsselte Funksignalverbindung zwischen allein dem jeweiligen Bauteil und dem Host-System abhörsicher ist.

Eine weitere vorteilhafte Ausgestaltung des Verfahrens zeichnet sich dadurch aus, dass das Verfahren außerdem die Schritte R1) und R2) aufweist. Gemäß Schritt R1) erfolgt ein Empfang eines Resetsignals über die dritte Funk-Signalschnittstelle des Bauteils oder einen Taster des Bauteils. Gemäß Schritt R2) erfolgt ein Zurücksetzen der Schlüsselkennung auf die in der Speichereinheit des Bauteils gespeicherten Initialschlüsselkennung. Empfängt ein Bauteil also beispielsweise ein Resetsignal, das entweder über die Funksignalschnittstelle des jeweiligen Bauteils oder über einen Taster des Bauteils verursacht ist, so kann das jeweilige Bauteil die Schlüsselkennung auf die Initialschlüsselkennung zurücksetzen, und damit die in Schritt Z1) empfangene, neue Schlüsselkennung verwerfen. Durch die Schritte R1) und R2) ist es möglich, dass ein Bauteil, wenn es versehentlich falsch verbaut wurde, wieder zurückgesetzt werden kann, und im Anschluss wie bei der ursprünglichen Verwendung verwendet werden kann und dabei eine geeignete, neue Schlüsselkennung zur sicheren Funkkommunikation mit dem Host-System erhalten kann.

Weitere Merkmale, Vorteile und Anwendungsmöglichkeiten der vorliegenden Erfindung ergeben sich aus der nachfolgenden Beschreibung der Ausführungsbeispiele und den Figuren. Dabei bilden alle beschriebenen und/oder bildlich dargestellten Merkmale für sich und in beliebiger Kombination den Gegenstand der Erfindung auch unabhängig von ihrer Zusammensetzung in den einzelnen Ansprüchen oder deren Rückbezügen. In den Figuren stehen weiterhin gleiche Bezugszeichen für gleiche oder ähnliche Objekte.
- Figur 1: zeigt eine vorteilhafte Ausgestaltung eines Flugzeugs in einer schematischen Perspektivansicht.
- Figur 2: zeigt eine vorteilhafte Ausgestaltung eines Aufbaus von Küchenschränken in einem Flugzeug in einer schematischen Darstellung.
- Figur 3: zeigt vorteilhafte Ausgestaltungen von einem Endgerät, einem Host-System und einer Vorrichtung für ein Flugzeug in einer schematischen Darstellung.
- Figur 4: zeigt eine weitere vorteilhafte Ausgestaltung einer Vorrichtung in einer schematischen Ansicht.
- Figur 5: zeigt eine vorteilhafte Ausgestaltung eines Blatt Papiers mit tabellarisch angeordneten Kennungen.
- Figuren 6-8: zeigen jeweils eine vorteilhafte Ausgestaltung eines Verfahrens in einem schematischen Ablaufplan.

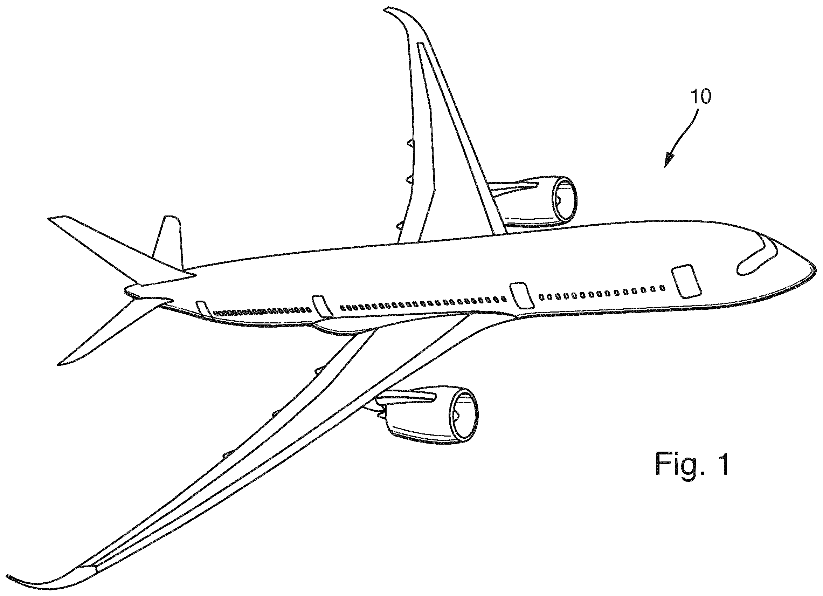

In der Figur 1 ist ein Flugzeug 10 schematisch dargestellt. Moderne Flugzeuge 10 weisen oftmals eine Vielzahl von Vorrichtungen 8, wie beispielsweise Sitze oder Schränke einer Küche 32 auf.

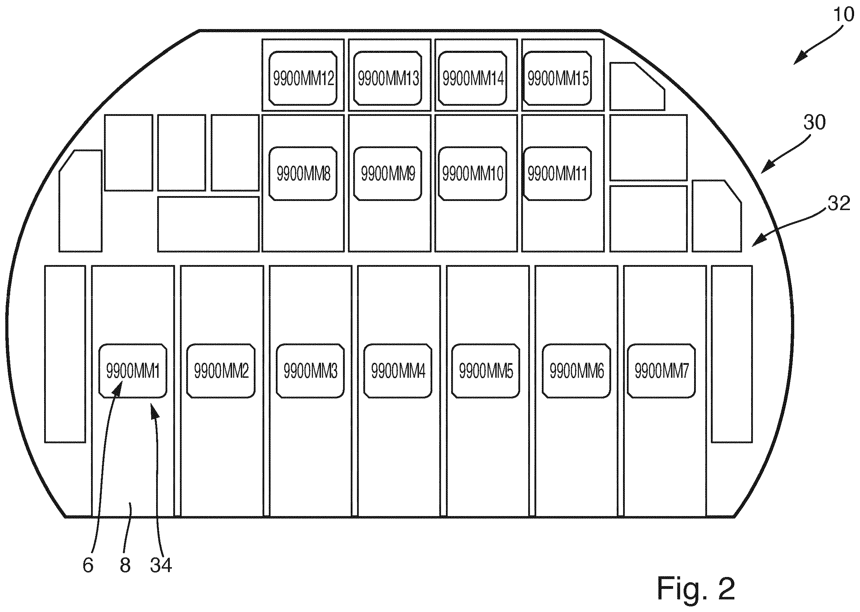

In der Figur 2 ist ein Teil des Rumpfs 30 des Flugzeugs 10 in einer schematischen Querschnittsdarstellung wiedergegeben. Die Figur 2 zeigt mehrere Schränke einer Küche 32. Mehrere der Schränke sind jeweils mit einem Vorrichtungsaufkleber 34 versehen, der eine Vorrichtungskennung 6 für den jeweiligen Schrank wiedergibt. Schränke, die einen Vorrichtungsaufkleber 34 mit einer zugehörigen Vorrichtungskennung 6 aufweisen, bilden Beispiele einer Vorrichtung 8 im Sinne der Erfindung. Diese Vorrichtungen 8 können sich von den übrigen Schränken (ohne Vorrichtungskennung 6) unterscheiden, indem jede der Vorrichtungen 8 mindestens ein Bauteil 12 aufweist, das zur Herstellung einer Kommunikationsverbindung, insbesondere einer Funkverbindung oder einer leitungsgebundenen Kommunikationsverbindung, ausgebildet ist. Derartige Bauteile 12 werden auch als kommunikationsfähige Bauteile 12 bezeichnet.

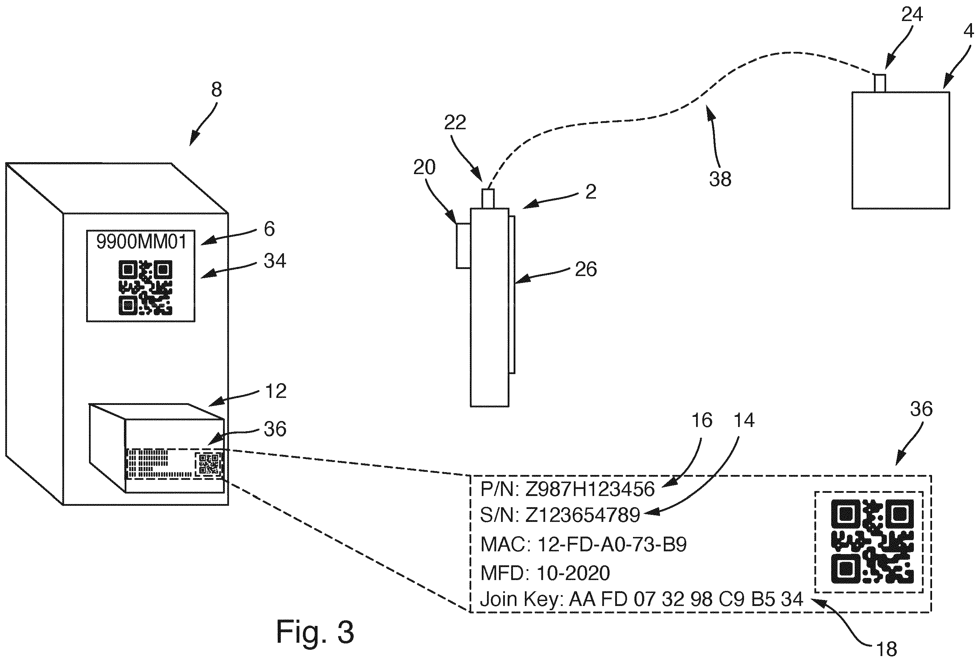

In der Figur 3 ist eine vorteilhafte Ausgestaltung der Vorrichtung 8 schematisch dargestellt. Die Vorrichtung 8 weist auf ihrer Außenseite einen Vorrichtungsaufkleber 34 auf, auf dem die Vorrichtungskennung 6 einerseits durch eine Kombination von Zahlen und Buchstaben und andererseits durch einen QR Code repräsentiert ist. Die Vorrichtungskennung 6 kann also in zweifacher Weise durch den Vorrichtungsaufkleber 34 wiedergegeben sein, nämlich einmal codiert durch den QR Code und einmal im Klartext durch die Kombination aus Zahlen und Buchstaben. Grundsätzlich ist es möglich, dass eine der beiden Wiedergabearten, also entweder der QR Code oder die Kombination aus Zahlen und Buchstaben, ausreichend ist, um der Vorrichtung 8 die Vorrichtungskennung 6 zuzuordnen.

Aus der Figur 3 ist außerdem ersichtlich, dass das kommunikationsfähige Bauteil 12 einen Teil der Vorrichtung 8 bildet. Das kommunikationsfähige Bauteil 12 kann ein modulares Bauteil der Vorrichtung 8 bilden. Es ist jedoch auch möglich, dass das kommunikationsfähige Bauteil 12 ein mit der Vorrichtung 8 fest verbundenes Bauteil der Vorrichtung 8 ist oder dass es einen integralen Bestandteil der Vorrichtung 8 bildet. Auf einer Außenseite des kommunikativen Bauteils 12 ist ein Bauteilaufkleber 36 aufgebracht. Der Bauteilaufkleber 36 ist in der Figur 3 seitlich zu dem kommunikationsfähigen Bauteil 12 vergrößert dargestellt. Aus der vergrößerten Darstellung des Bauteilaufklebers 36 ist zu erkennen, dass durch den Bauteilaufkleber 36 mehrere Kennungen 14, 16, 18 wiedergegeben sind und dadurch auch dem kommunikationsfähigen Bauteil 12 zugeordnet sind. Durch den Bauteilaufkleber 36 wird dem kommunikationsfähigen Bauteil 12 deshalb eine zugehörige, eindeutige Teilnehmerkennung 14, eine nicht-eindeutige Teilekennung 16 und eine Initialschlüsselkennung 18 zugeordnet. Die Teilnehmerkennung 14 kann auch als Client ID oder als S/N bezeichnet sein. Die Teilekennung 16 kann auch als Client Part Nr. bezeichnet sein. Die Initialschlüsselkennung 18 kann auch als Join Key, Pre-Shared Key, Schlüssel oder Zertifikat bezeichnet sein.

Die Vorrichtungskennung 6 ist für jede Vorrichtung 8 eindeutig. Über die Vorrichtungskennung 6 kann die Vorrichtung 8 deshalb eindeutig identifiziert werden. Für jedes kommunikationsfähige Bauteil 12 einer Vorrichtung 8 ist jeweils eine zugehörige, eindeutige Teilnehmerkennung 14 vorgesehen. Über die Teilnehmerkennung 14 kann das jeweilige Bauteil 12 deshalb eindeutig identifiziert werden. Jedem Bauteil 12 ist außerdem die Teilekennung 16 zugeordnet. Die Teilekennung 16 kann über den Typ, die Kategorie, die Gruppe oder andere, generelle technische Merkmale des jeweiligen Bauteils 12 Auskunft geben. Da die Teilekennung 16 nicht eindeutig ist, kann über die Teilekennung 16 keine eindeutige Identifizierung des Bauteils 12 erfolgen. Hierzu ist vorzugsweise ausschließlich die Teilnehmerkennung 14 geeignet. Die Teilekennung 16 eignet sich aber zur Feststellung, welche technischen Merkmale das jeweilige Bauteil 12 aufweist und/oder welche technischen Spezifikationen das jeweilige Bauteil 12 erfüllt. Insbesondere können über die Teilekennung 16 die Art und/oder der Typ des jeweiligen Bauteils 12 bestimmt sein. Die Teilekennung 16 kann beispielsweise einen kommunikativen Feuchtigkeitssensor spezifizieren. In der Küche 32 des Flugzeugs 10 können mehrere Schränke mit einem kommunikativen Feuchtigkeitssensor ausgebildet sein, so dass diese Schränke jeweils eine Vorrichtung 8 bilden, die ein kommunikationsfähiges Bauteil 12, nämlich den kommunikativen Feuchtigkeitssensor, umfassen. Der kommunikative Feuchtigkeitssensor ist aber nicht das einzige Beispiel für ein kommunikationsfähiges Bauteil 12 in der Küche 32. So können auch andere elektrische Geräte in einem Schrank der Küche 32 angeordnet sein und außerdem zur Herstellung einer Kommunikationsverbindung ausgebildet sein. So kann ein weiterer Schrank beispielsweise eine Vorrichtung 8 bilden, wenn dieser Schrank als kommunikationsfähiges Bauteil 12 eine Kaffeemaschine aufweist, die ebenfalls zur Herstellung einer Kommunikationsverbindung ausgebildet ist. Jedes der Bauteile 12 der mehreren Vorrichtungen 8 kann dazu ausgebildet sein, um eine Kommunikationsverbindung zu der gleichen Kommunikationseinheit des Flugzeugs 10 herzustellen. Diese Kommunikationseinheit kann beispielsweise das Host-System 4 sein, wenn dieses Bestandteil des Flugzeugs 10 ist. Anderenfalls kann eine andere Kommunikationseinheit des Flugzeugs 10 zur Herstellung der Kommunikationsverbindung zu den kommunikationsfähigen Bauteilen 12 ausgebildet sein.

Bei der Planung zur Herstellung eines Flugzeugs 10 wird oftmals festgelegt, an welcher Stelle Vorrichtungen 8 mit zugehörigen Bauteilen 12 zu installieren sind. Für eine vorteilhafte Ausgestaltung des Verfahrens der Erfindung ist es vorgesehen, dass bei der Installation der Vorrichtungen ein mobiles Endgerät 2 eingesetzt wird, das zur direkten oder indirekten optischen Erfassung der Vorrichtungskennung 6, der Teilnehmerkennung 14, der Teilekennung 16 und der Initialschlüsselkennung 18 ausgebildet ist. In der Figur 3 ist das mobile Endgerät 2 beispielhaft als ein speziell konfiguriertes Mobiltelefon dargestellt, das eine Kamera 20 sowie ein Display 26 aufweist. Das Display 26 kann beispielsweise von einem Bildschirm gebildet sein. Die Kamera 20 und das Display 26 können an gegenüberliegenden Außenseiten des mobilen Endgeräts 2 angeordnet sein. Außerdem kann das mobile Endgerät 2 eine erste Signalschnittstelle 22 aufweisen, die zur Herstellung einer Signalverbindung 38, insbesondere einer Funk-Signalverbindung 38, zu einer zweiten Signalschnittstelle 24 des Host-Systems 4 ausgebildet ist. Werden Vorrichtungen 8 beispielsweise in der Küche 32 des Flugzeugs 10 installiert, kann das mobile Endgerät 2 dazu verwendet werden, um die Vorrichtungen 8 nacheinander mittels der Kamera 20 des mobilen Endgeräts 2 zu fotografieren und auf diese Weise die zuvor genannten Kennungen 6, 14, 16, 18 optisch zu erfassen. Aus diesen Kennungen bildet das mobile Endgerät 2 mindestens einen Hauptdatensatz, den das mobile Endgerät 2 über die Signalverbindung 38 in Form eines Konfigurationssignals an das Host-System 4 übermittelt.

Für jede Vorrichtung 8 wird vorzugsweise genau ein zugehöriger Hauptdatensatz erzeugt. Hierzu kann das mobile Endgerät 2 entsprechend konfiguriert sein. Dabei wird jeder Hauptdatensatz derart gebildet, dass jeder Hauptdatensatz genau eine zugehörige, eindeutige Vorrichtungskennung 6 der jeweiligen Vorrichtung 8 des Flugzeugs 10 repräsentiert und für diese jeweilige Vorrichtung 8 mindestens einen Hilfsdatensatz umfasst, der jeweils genau einem Bauteil 12 der jeweiligen Vorrichtung 8 eindeutig zugeordnet ist. Der Hauptdatensatz umfasst also die für die Vorrichtung 8 eindeutige und zugehörige Vorrichtungskennung 6 sowie für jedes kommunikationsfähige Bauteil 12 dieser Vorrichtung 8 einen jeweils zugehörigen Hilfsdatensatz. Weist eine Vorrichtung 8 beispielsweise zwei kommunikationsfähige Bauteile 12 auf, so wird der Hauptdatensatz die für die Vorrichtung 8 eindeutige Vorrichtungskennung 6 sowie zwei Hilfsdatensätze aufweisen, wobei jeder Hilfsdatensatz eindeutig und genau nur einem der beiden kommunikationsfähigen Bauteile 12 zugeordnet ist. Jeder Hilfsdatensatz umfasst eine zugehörige, eindeutige Teilnehmerkennung **14** des jeweiligen Bauteils 12, eine nicht-eindeutige Teilekennung 16 des jeweiligen Bauteils 12 und eine Initialschlüsselkennung 18. Die Initialschlüsselkennungen 18 sind ebenfalls nicht eindeutig für das jeweilige Bauteil 12. Vielmehr können die Initialschlüsselkennungen 18 für die mehreren Bauteile 12 gleich sein. Die nicht-eindeutigen Teilekennungen 16 können zwar gleich sein, sie müssen es jedoch nicht. Weist die Vorrichtung 8 beispielsweise zwei unterschiedliche Typen von kommunikativen Sensoren als kommunikationsfähige Bauteile 12 auf, so werden sich dabei die Teilekennungen 16 ebenfalls unterscheiden.

Durch die Übertragung jedes Hauptdatensatzes durch das Konfigurationssignal von dem mobilen Endgerät 2 zu dem Host-System 4 werden dem Host-System 4 die Informationen über die verbaute Vorrichtung 8 und die zugehörigen, kommunikationsfähigen Bauteile 12 übermittelt.

Bereits vor der Herstellung des Flugzeugs 10 wird oftmals festgelegt, welche Vorrichtungen 8 für das Flugzeug 10 verwendet werden sollen, und welche kommunikationsfähigen Bauteile 12 die jeweiligen Vorrichtungen 8 aufweisen sollen. Die Vorrichtungskennungen 6 können für die Vorrichtungen 8 bereits vorbestimmt sein. Für die kommunikationsfähigen Bauteile 12 einer jeweiligen Vorrichtung 8 ist es außerdem bevorzugt vorgesehen, dass für diese zugehörigen kommunikationsfähigen Bauteile 12 jeweils eine Teilekennung 16 als auch eine sogenannte Referenzteilekennung vorbestimmt ist. Vor diesem Hintergrund ist in dem Host-System 4 ein Referenzdatensatz gespeichert, der eine Vielzahl von Vorrichtungskennungen 6 und für jede Vorrichtungskennung 6 mindestens eine zugeordnete, nicht-eindeutige Referenzteilekennung umfasst. Jede der Referenzteilekennungen kann als ein Sollwert für die tatsächliche Teilekennung 16 eines Bauteils 12 verstanden werden, das in der Vorrichtung 8 mit der jeweiligen Vorrichtungskennung 6 verbaut und/oder integriert ist.

Wird bei der Installation einer Vorrichtung 8 sowohl die Vorrichtungskennung 6 der Vorrichtung 8 als auch die jedem kommunikationsfähigen Bauteil 12 zugeordneten Kennungen 14, 16, 18 erfasst, erhält das Host-System 4 über den entsprechenden Hauptdatensatz eine Kombination von Kennungen der tatsächlich verbauten Vorrichtung 8, die das Host-System 4 mit den Kennungen aus dem Referenzdatensatz vergleichen kann.

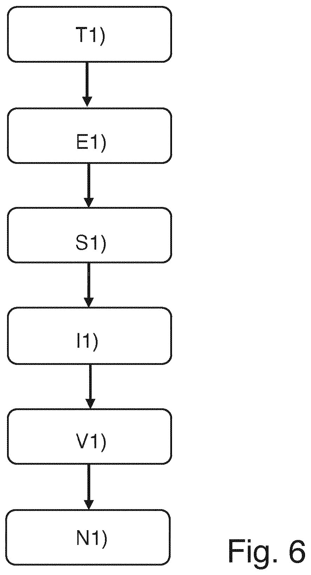

Das erfindungsgemäße Verfahren, wie es beispielhaft und schematisch in dem Ablaufplan der Figur 6 dargestellt ist, umfasst also zunächst den Schritt T1), gemäß dem ein Übertragen eines Konfigurationssignals von dem Endgerät 2 an das Host-System 4 erfolgt, wobei das Kommunikationssignal mindestens einen Hauptdatensatz repräsentiert. In Schritt E1) erfolgt der Empfang dieses Konfigurationssignals mittels des Host-Systems 4. In Schritt S1) erfolgt das Speichern des mindestens einen, mittels des Konfigurationssignals empfangenen Hauptdatensatzes von dem Host-System 4.

Nachdem ein Hauptdatensatz von dem Host-System 4 empfangen und gespeichert ist, erfolgt in Schritt I1) mittels des Host-Systems ein Identifizieren der Vorrichtungskennung 6 eines jeweiligen Hauptdatensatzes, der mittels des Konfigurationssignals übertragen worden ist, in dem Referenzdatensatz und ein Auslesen der mindestens einen zugehörigen, nicht eindeutigen Referenzteilekennung 16 aus dem Referenzdatensatz. Das Host-System 4 identifiziert also zunächst die Vorrichtungskennung 6 des Hauptdatensatzes in der Vielzahl der Vorrichtungskennungen 6 des Referenzdatensatzes. Ist die richtige Vorrichtungskennung 6 in dem Referenzdatensatz identifiziert, wird die mindestens eine, zugehörige Referenzteilekennung 16 aus dem Referenzdatensatz mittels des Host-Systems ausgelesen und damit für die tatsächliche Vorrichtungskennung 6 der jeweiligen Vorrichtung 8 bestimmt. Weist die Vorrichtung 8 mit einer Vorrichtungskennung 6 mehrere kommunikationsfähige Bauteile 12 auf, können der Vorrichtungskennung 6 auch mehrere Referenzkennungen zugeordnet sein, die in Schritt I1) entsprechend bestimmt werden können. Über die Vorrichtungskennung 6 aus dem Hauptdatensatz ist es in Schritt I1) deshalb möglich, mindestens eine Referenzteilekennung für die zugehörige Vorrichtung zu bestimmen.

In Schritt V1) erfolgt mittels des Host-Systems 4 ein Vergleich der mindestens einen Teilekennung 16, die von dem mindestens einen Hilfsdatensatz des Hauptdatensatzes umfasst ist, mit der mindestens einen Referenzteilekennung, die für die jeweilige Vorrichtungskennung 6 des Hauptdatensatzes in Schritt I1) identifiziert wurde. Das Ergebnis des Vergleichs kann beispielsweise eine positive Übereinstimmung zwischen der mindestens einen Referenzteilekennung und der tatsächlichen Teilekennung 16 sein. Bestehen Unterschiede, kann eine Nicht-Übereinstimmung das Ergebnis des Vergleichs sein.

In Schritt N1) erfolgt deshalb mittels des Host-Systems 4 ein Erzeugen und Versenden eines Reportsignals, das das Ergebnis des Vergleichs aus Schritt V1) repräsentiert. Das Reportsignal kann beispielsweise über die Signalverbindung 38 von dem Host-System 4 an das mobile Endgerät 2 gesendet werden, so dass auf dem Display 26 des mobilen Endgeräts 2 eine Nachricht ausgegeben wird, die das Ergebnis des Vergleichs optisch repräsentiert. Der Benutzer des mobilen Endgeräts 2 erhält damit Auskunft darüber, ob die jeweils zuvor installierte Vorrichtung 8 die richtigen Bauteile 12 umfasst. Liegt eine positive Übereinstimmung vor, kann der Benutzer des mobilen Endgeräts 2 zu der nächsten Vorrichtung 8 weiterschreiten. Besteht keine Übereinstimmung, sondern Unterschiede, kann der Benutzer einen Austausch der kommunikationsfähigen Bauteile 12 veranlassen, so dass das falsche kommunikationsfähige Bauteil 12 durch ein richtiges kommunikationsfähiges Bauteil 12 ersetzt wird.

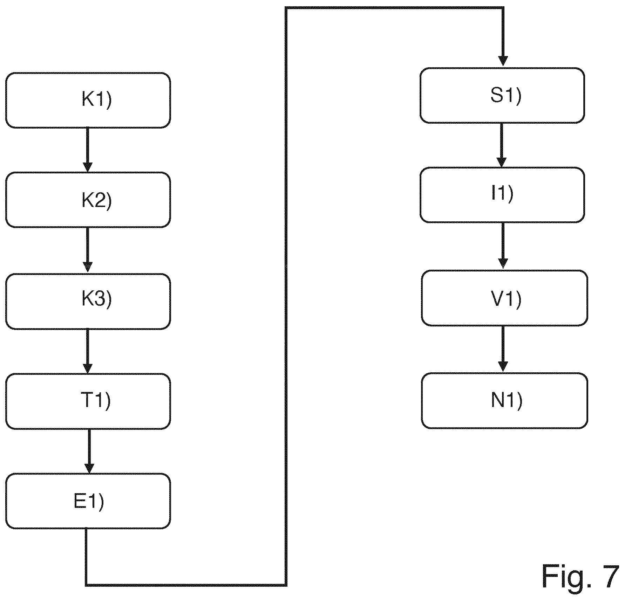

Bereits zuvor wurde erwähnt, dass das mobile Endgerät 2 zur optischen Erfassung der Kennungen 6, 14, 16, 18 ausgebildet sein kann. In Figur 7 ist eine weitere vorteilhafte Ausgestaltung des Verfahrens durch einen schematischen Ablaufplan wiedergegeben. Das Verfahren umfasst die Schritte, wie sie im Zusammenhang mit Figur 6 erläutert worden sind. Darüber hinaus umfasst das Verfahren die Schritte K1), K2) und K3). Wie aus der Figur 7 zu entnehmen ist, ist es bevorzugt vorgesehen, dass die Schritte K1), K2) und K3) nacheinander ausgeführt werden. Es ist jedoch auch möglich, dass die Schritte K1) und K2) gleichzeitig oder zumindest zeitlich überlappend ausgeführt werden. Schritt K3) wird vorzugsweise dann ausgeführt, wenn die beiden Schritte K1) und K2) beendet sind. Außerdem ist es bevorzugt vorgesehen, dass die Schritte K1), K2) und K3) vor Schritt T1) ausgeführt werden.

Gemäß Schritt K1) erfolgt ein direktes oder indirektes, optisches Erfassen einer Vorrichtungskennung 6 auf der Vorrichtung 8 mittels des Endgeräts 2. Hierzu kann die Kamera 20 eingesetzt werden. Außerdem ist dieser Schritt K1) insbesondere dann von Vorteil, wenn die Vorrichtungskennung 6 auf einem Vorrichtungsaufkleber 36 optisch dargestellt ist, wobei der Vorrichtungsaufkleber 34 auf einer Außenseite der Vorrichtung 8 aufgeklebt ist.

Gemäß Schritt K2) erfolgt ein direktes oder indirektes, optisches Erfassen von einer Teilnehmerkennung 14, einer nicht-eindeutigen Teilekennung 16 und einer Initialschlüsselkennung 18 auf jedem Bauteil 12 der Vorrichtung 8 aus Schritt K1) mittels des Endgeräts 2. Hierzu kann ebenfalls die Kamera 20 des mobilen Endgeräts 2 eingesetzt werden. Die Kennungen 14, 16, 18 können gemeinsam auf einem Bauteilaufkleber 36 optisch dargestellt sein, wobei der Bauteilaufkleber 36 auf einer Außenseite des jeweiligen kommunikativen Bauteils 12 aufgeklebt ist. Jedes kommunikationsfähige Bauteil 12 kann einen entsprechenden Bauteilaufkleber 36 an der Außenseite aufweisen. Zumindest die Teilnehmerkennungen 14 auf den Bauteilaufklebern 36 unterscheiden sich zwischen den kommunikationsfähigen Bauteilen 12. Der Schritt K2) kann somit für jedes kommunikationsfähige Bauteil 12 einer jeweiligen Vorrichtung 8 einzeln ausgeführt werden.

Gemäß Schritt K3) erfolgt ein Erzeugen des Hauptdatensatzes für die jeweilige Vorrichtung 8 aus der in Schritt K1) erfassten, zugehörigen Vorrichtungskennung 6 und des mindestens einen zugehörigen Hilfsdatensatzes mit den in Schritt K2) jeweils erfassten Kennungen 14, 16, 18 mittels des mobilen Endgeräts 2. Umfasst die Vorrichtung 8 beispielsweise zwei mobile Bauteile 12, so umfasst der in Schritt K3) erzeugte Hauptdatensatz neben der Vorrichtungskennung 6 der Vorrichtung 8 zwei Hilfsdatensätze, wobei jedem Bauteil 12 genau einer der beiden Hilfsdatensätze eindeutig zugeordnet ist. Die Hilfsdatensätze können ebenfalls von dem mobilen Endgerät 2 erzeugt werden, und zwar aus den Kennungen 14, 16, 18 der Bauteilaufkleber 36 des jeweiligen Bauteils 12. Ist der Hauptdatensatz in Schritt K3) erzeugt, kann im Anschluss der Schritt T1) erfolgen, nämlich das Übertragen eines Konfigurationssignals von dem mobilen Endgerät 2 an das Host-System 4, wobei das Konfigurationssignal den Hauptdatensatz repräsentiert.

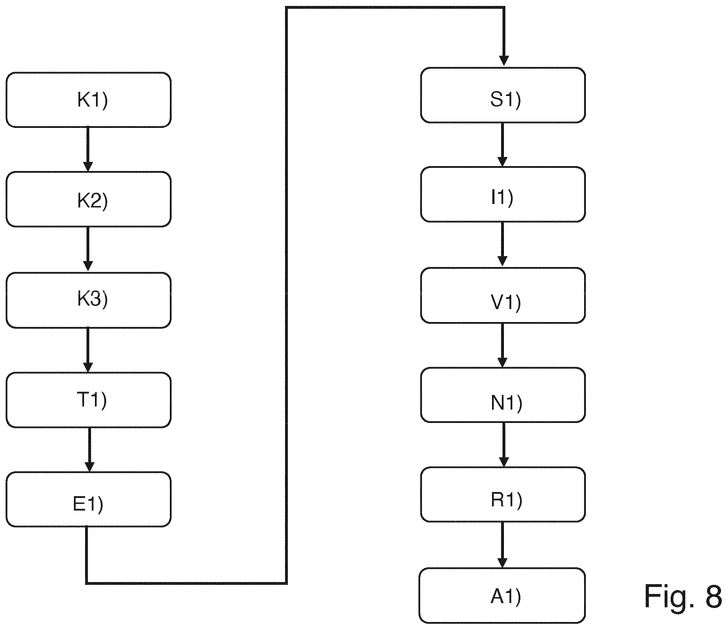

In der Figur 8 ist eine weitere, vorteilhafte Ausgestaltung des Verfahrens durch einen schematischen Ablaufplan dargestellt. Diese Ausgestaltung des Verfahrens umfasst die Schritte, wie sie im Zusammenhang mit Figur 7 erläutert worden sind, so dass auf die Erläuterungen zu Figur 7 in analoger Weise Bezug genommen wird. Aus der Figur 8 ist zu erkennen, dass im Anschluss an Schritt N1) zwei weitere Schritte R1) und A1) ausgeführt werden. Gemäß Schritt R1), der im Anschluss an Schritt N1) ausgeführt werden kann, erfolgt ein Empfang des Reportsignals von dem Host-System 4 mittels der Signalschnittstelle 22 des Endgeräts 2. Dadurch erhält das mobile Endgerät 2 die Information, ob der Vergleich aus Schritt V1) eine Übereinstimmung zwischen der mindestens einen Referenzteilekennung und der tatsächlichen Teilekennung 16 als Ergebnis hat oder ob das Ergebnis des Vergleichs aus Schritt V1) Unterschiede zwischen der mindestens einen Referenzteilekennung und der tatsächlichen Teilekennung 16 als Ergebnis hat. Gemäß Schritt A1), der im Anschluss an Schritt R1) ausgeführt werden kann, erfolgt ein Anzeigen einer Nachricht auf dem Display 26 des Endgeräts 2, wobei die Nachricht das Ergebnis des Vergleichs aus Schritt V1) optisch repräsentiert. Der Benutzer des Endgeräts 2 erhält also über die auf dem Display 26 angezeigte Nachricht die Information darüber, ob die Vorrichtung 8 und das mindestens eine zugehörige, kommunikationsfähige Bauteil 12 richtig installiert ist.

Das mobile Endgerät 2 kann derart verwendet werden, dass jeder Hauptdatensatz, sobald dieser erzeugt ist, von dem mobilen Endgerät 2 über das Konfigurationssignal an das Host-System 4 übertragen wird. Es ist jedoch auch möglich, dass mit dem mobilen Endgerät 2 eine Vielzahl von Hauptdatensätzen erzeugt werden, nachdem die Kennungen 6, 14, 16, 18 auf mehreren Vorrichtungen 8 und zugehörigen, kommunikationsfähigen Bauteilen 12 erfasst sind. Für jede Vorrichtung 8 kann somit genau ein eindeutig und zugehöriger Hauptdatensatz von dem mobilen Endgerät 2 erzeugt sein. Diese mehreren Hauptdatensätze können gemeinsam über das Konfigurationssignal von dem mobilen Endgerät 2 an das Host-System 4 über das Konfigurationssignal gesendet werden.

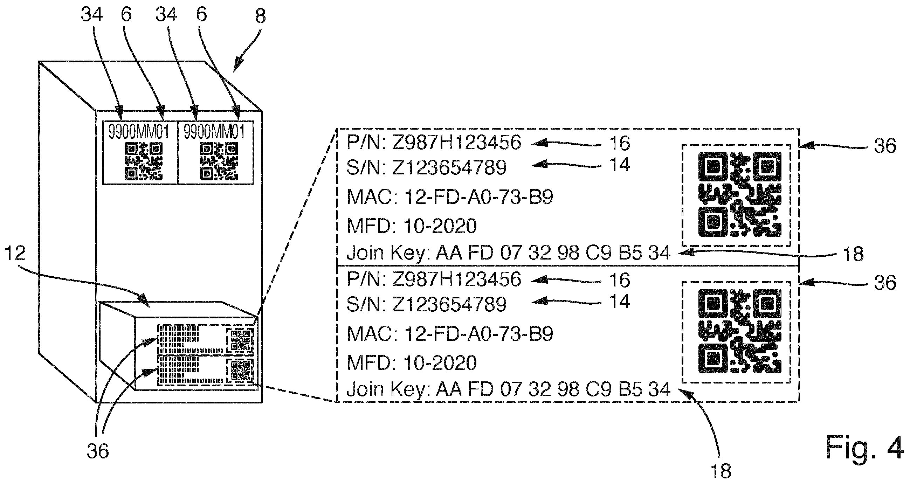

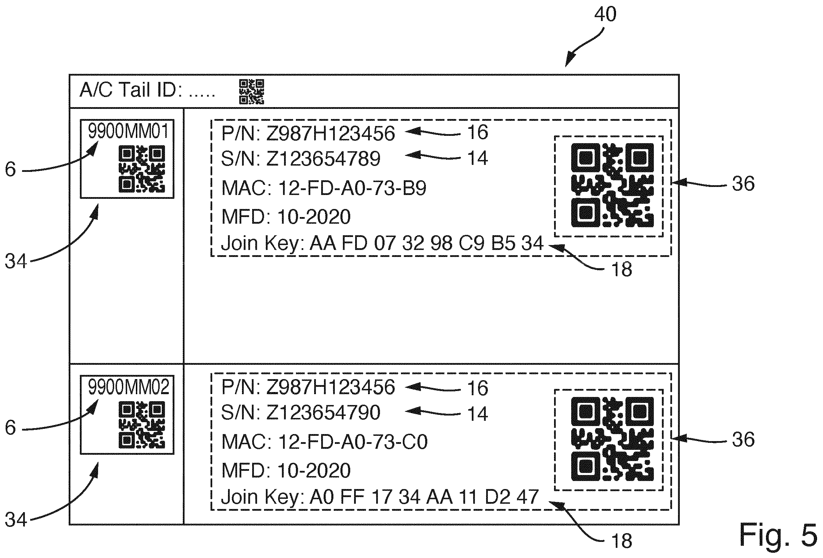

Für die Erzeugung des Hauptdatensatzes und die Erfassung der Kennungen 6, 14, 16, 18 der Vorrichtung 8 beziehungsweise der Bauteile 12 ist jedoch nicht zwingend ein mobiles Endgerät 2 notwendig. Dieses soll beispielhaft mit Hilfe der Figuren 4 und 5 erläutert werden.

In der Figur 4 ist eine Vorrichtung 8 schematisch dargestellt, die genau ein kommunikationsfähiges Bauteil 12 aufweist. An der Außenseite der Vorrichtung 8 sind zwei identische Vorrichtungsaufkleber 34 aufgebracht, die jeweils die gleiche Vorrichtungskennung 6 im Klartext oder durch einen QR-Code repräsentieren. An der Außenseite des Bauteils 12 sind außerdem zwei identische Bauteilaufkleber 36 angebracht, die jeweils die gleiche Teilnehmerkennung 14, die gleiche nicht-eindeutige Teilekennung 16 und die gleiche Initialschlüsselkennung 18 im Klartext oder durch einen QR-Code repräsentieren. Einer der Vorrichtungsaufkleber 34 kann abgezogen werden und auf ein Blatt Papier 40 aufgeklebt werden, wie es beispielsweise in der Figur 5 schematisch dargestellt ist. Das Blatt Papier 40 kann tabellarisch unterteilt sein. Der Vorrichtungsaufkleber 34 kann in einer linken Spalte angeordnet sein. Bei dem Blatt 40 sind zwei Zeilen vorgesehen, so dass in der zweiten Zeile ein weiterer Vorrichtungsaufkleber 34 einer anderen (nicht dargestellten) Vorrichtung 8 aufgeklebt ist. In der ersten Zeile ist der Vorrichtungsaufkleber 34 der Vorrichtung 8 aus Figur 4 aufgeklebt. Rechts zu dem Vorrichtungsaufkleber 34 in der gleichen Zeile ist einer der Bauteilaufkleber 34 des Bauteils 12 der Vorrichtung 8 aufgeklebt, der zuvor von dem Bauteil 12 abgezogen wurde. Durch das entsprechende Aufkleben der Vorrichtungsaufkleber 34 und der Bauteilaufkleber 36 kann eine Zuordnung von der Vorrichtungskennung 6 und der Kennungen 14, 16, 18 des jeweiligen Bauteils 12 der Vorrichtung 8, zu der die Vorrichtungskennung 6 gehört, erfolgen. Weist die Vorrichtung 8 mehrere Bauteile 12 auf, können in der gleichen Zeile mehrere Bauteilaufkleber 36 der unterschiedlichen Bauteile 12 aufgeklebt werden, wobei jeder Bauteilaufkleber 36 Kennungen 14, 16, 18 für einen Hilfsdatensatz bereitstellt, der dem jeweiligen Bauteil 12 zugeordnet ist. Das in Figur 5 dargestellte Blatt 40 kann von einem stationären Endgerät 2 mit einem zugehörigen Scanner eingescannt werden. Das stationäre Endgerät 2 kann zur Erzeugung eines Hauptdatensatzes für jede Vorrichtung 8 ausgebildet sein, so dass jeder Hauptdatensatz eine Vorrichtungskennung 6 aufweist, die durch den jeweiligen Vorrichtungsaufkleber 34 bestimmt ist, und für jedes Bauteil 12 einen zugehörigen Hilfsdatensatz umfassen, der durch die Kennungen 14, 16, 18 auf dem Bauteilaufkleber 36 wiedergegeben ist, der in der gleichen Zeile wie der Vorrichtungsaufkleber 34 mit der Vorrichtungskennung 6 für den jeweiligen Hauptdatensatz angeordnet ist. Durch das Scannen des Blatts 40, wie es beispielsweise auf Seite 5 dargestellt ist, können mehrere Hauptdatensätze erzeugt werden und mittels eines Konfigurationssignals, das von dem stationären Endgerät 2 erzeugt wird, über eine Signalverbindung 38 an das Host-System 4 übertragen werden.

Ergänzend sei darauf hingewiesen, dass "aufweisend" keine anderen Elemente oder Schritte ausschließt und "ein" oder "eine" keine Vielzahl ausschließt. Ferner sei darauf hingewiesen, dass Merkmale, die mit Verweis auf eines der obigen Ausführungsbeispiele beschrieben worden sind, auch in Kombination mit anderen Merkmalen anderer oben beschriebener Ausführungsbeispiele verwendet werden können. Bezugszeichen in den Ansprüchen sind nicht als Einschränkung anzusehen.

### Bezugszeichenliste

- 2: Endgerät
- 4: Host-System
- 6: Vorrichtungskennung
- 8: Vorrichtung
- 10: Flugzeug
- 12: Bauteil
- 14: Teilnehmerkennung
- 16: Teilekennung
- 18: Initalschlüsselkennung
- 20: Kamera
- 22: erste Signalschnittstelle
- 24: zweite Signalschnittstelle
- 26: Display
- 30: Rumpf
- 32: Küche
- 34: Vorrichtungsaufkleber
- 36: Bauteilaufkleber
- 38: Signalverbindung
- 40: Blatt

## Patentansprüche

1. Verfahren zum Feststellen, ob mit einer Vielzahl von kommunikationsfähigen Bauteilen in einem Flugzeug eindeutig kommuniziert werden kann, aufweisend die Schritte:
T1) Übertragen eines Konfigurationssignals von einem Endgerät (2) an ein Host-System (4), wobei das Konfigurationssignal mindestens einen Hauptdatensatz repräsentiert,
wobei jeder Hauptdatensatz genau eine zugehörige, eindeutige Vorrichtungskennung (6) einer jeweiligen Vorrichtung (8) eines Flugzeugs (10) repräsentiert und für diese jeweilige Vorrichtung (8) mindestens einen Hilfsdatensatz umfasst, der jeweils genau einem Bauteil (12) der jeweiligen Vorrichtung (8) eindeutig zugeordnet ist,
wobei jeder Hilfsdatensatz eine zugehörige, eindeutige Teilnehmerkennung (14) des jeweiligen Bauteils (12), eine nicht-eindeutige Teilekennung (16) des jeweiligen Bauteils (12) und eine Initialschlüsselkennung (18) umfasst,
wobei von dem Host-System (4) ein Referenzdatensatz (Soll) gespeichert ist, der eine Vielzahl von Vorrichtungskennungen (6) und für jede Vorrichtungskennung (6) mindestens eine zugeordnete, nicht-eindeutige Referenzteilekennung umfasst;
E1) Empfang des Konfigurationssignals mittels des Host-Systems (4);
S1) Speichern des mindestens einen, mittels des Konfigurationssignals empfangenen Hauptdatensatzes von dem Host-System (4);
I1) Identifizieren der Vorrichtungskennung (6) eines jeden Hauptdatensatzes, der mittels des Konfigurationssignals empfangen wird, in dem Referenzdatensatz mittels des Host-Systems (4) und ein Bestimmen der mindestens einen zu der identifizierten Vorrichtungskennung (6) zugehörigen, nicht-eindeutigen Referenzteilekennung in dem Referenzdatensatz mittels des Host-Systems (4);
V1) Vergleichen der mindestens einen Teilekennung (16), die von dem mindestens einen Hilfsdatensatzes eines jeweiligen Hauptdatensatzes umfasst ist, mit der mindestens einen Referenzteilekennung, die für die jeweilige Vorrichtungskennung (6) des jeweiligen Hauptdatensatzes in Schritt I1) identifiziert wurde mittels des Host-Systems (4); und
N1) Erzeugen und Versenden eines Reportsignals mittels des Host-Systems (4), so dass das Reportsignal ein Ergebnis des Vergleichs aus Schritt V1) repräsentiert, wobei das Reportsignal ablesbar ist, um festzustellen, ob die im Flugzeug (10) verbauten Vorrichtungen (8), die jeweils kommunikationsfähige Bauteile aufweisen, richtig verbaut sind.

2. Verfahren nach dem vorhergehenden Anspruch, **dadurch gekennzeichnet, dass** in Schritt V1) mittels des Host-Systems (4) überprüft wird, ob die miteinander zu vergleichenden Teilekennungen (16) und Referenzteilekennungen übereinstimmen, und das Reportsignal in Schritt N1) mittels des Host-Systems (4) derart erzeugt wird, dass das Ergebnis eine positive Übereinstimmung repräsentiert, wenn die Überprüfung aus Schritt V1) keine Unterschiede ergibt, und anderenfalls die voneinander abweichenden Kennungen (6, 14, 16, 18) durch das Reportsignal indiziert.

3. Verfahren nach einem der vorhergehenden Ansprüche, **dadurch gekennzeichnet, dass** das Konfigurationssignal mehrere Hauptdatensätze repräsentiert.

4. Verfahren nach einem der vorhergehenden Ansprüche, **dadurch gekennzeichnet, dass** das Endgerät (2) ein stationäres Endgerät (2) mit einem Papierscanner ist.

5. Verfahren nach einem der vorhergehenden Ansprüche 1 bis 3, **dadurch gekennzeichnet, dass** das Endgerät (2) ein mobiles Endgerät (2) ist.

6. Verfahren nach dem vorhergehenden Anspruch, **dadurch gekennzeichnet, dass** das mobile Endgerät (2) eine Kamera (20) aufweist, wobei das Verfahren außerdem die folgenden Schritte K1), K2) und K3) aufweist, die vor Schritt T1) ausgeführt werden:
K1) Direktes oder indirektes, optisches Erfassen von einer Vorrichtungskennung (6) auf einer Vorrichtung (8) mittels des Endgeräts (2); und
K2) Direktes oder indirektes, optisches Erfassen von einer Teilnehmerkennung (14), einer nicht-eindeutigen Teilekennung (16) und einer Initialschlüsselkennung (18) auf jedem Bauteil (12) der Vorrichtung (8) aus Schritt K1) mittels des Endgeräts (2); und
K3) Erzeugen des Hauptdatensatzes für jede Vorrichtung (8) aus der in Schritt K1) erfassten, zugehörigen Vorrichtungskennung (6) und des mindestens einen zugehörigen Hilfsdatensatzes mit den in Schritt K2) erfassten Kennungen (14, 16, 18) mittels des Endgeräts (2).

7. Verfahren nach Anspruch 5, **dadurch gekennzeichnet, dass** das mobile Endgerät (2) einen Nahfeld-Leser aufweist, wobei das Verfahren außerdem die folgenden Schritte K1), K2) und K3) aufweist, die vor Schritt T1) ausgeführt werden:
K1) Direktes oder indirektes, elektromagnetisches Erfassen von einer Vorrichtungskennung (6) auf einer Vorrichtung (8) mittels des Endgeräts (2); und
K2) Direktes oder indirektes, elektromagnetisches Erfassen von einer Teilnehmerkennung (14), einer nicht-eindeutigen Teilekennung (16) und einer Initialschlüsselkennung (18) auf jedem Bauteil (12) der Vorrichtung (8) aus Schritt K1) mittels des Endgeräts (2);
K3) Erzeugen des Hauptdatensatzes für jede Vorrichtung (8) aus der in Schritt K1) erfassten, zugehörigen Vorrichtungskennung (6) und des mindestens einen zugehörigen Hilfsdatensatzes mit den in Schritt K2) erfassten Kennungen (14, 16, 18) mittels des Endgeräts (2).

8. Verfahren nach einem der vorhergehenden Ansprüche 5 bis 7, **dadurch gekennzeichnet, dass** in Schritt T1) in mehreren, aufeinanderfolgenden Zeitfenstern jeweils mindestens ein Hauptdatensatz von dem Endgerät (2) an das Host-System (4) übertragen wird.

9. Verfahren nach einem der vorhergehenden Ansprüche, **dadurch gekennzeichnet, dass** das Endgerät (2) eine erste Signalschnittstelle (22) und das Host-System (4) eine zweite Signalschnittstelle (24) aufweisen, wobei die Signalschnittstellen (22, 24) zur Übertragung eines Signals ausgebildet sind.

10. Verfahren nach Anspruch 9, **dadurch gekennzeichnet, dass** das Endgerät (2) ein Display (26) aufweist und die erste Signalschnittstelle (22) zum Empfang des Reportsignals ausgebildet ist, und wobei das Verfahren die folgenden Schritte aufweist:
R1) Empfang des Reportsignals mittels der ersten Signalschnittstelle (22) des Endgeräts (2); und
A1) Anzeigen einer Nachricht, die das Ergebnis des Vergleichs aus Schritt V1) optisch repräsentiert, basierend auf dem Reportsignal und mittels des Displays (26) des Endgeräts (2).

11. Verfahren nach einem der vorhergehenden Ansprüche 9 bis 10, **dadurch gekennzeichnet, dass** die erste Schnittstelle (22) und zweite Schnittstelle (24) jeweils als Funkschnittstelle ausgebildet sind, wobei das Konfigurationssignal in Schritt T1) als Funk-Konfigurationssignal übertragen wird, und wobei das Reportsignal in Schritt N1) als Funk-Reportsignal versendet wird.

12. Verfahren nach einem der vorhergehenden Ansprüche 9 bis 11, **dadurch gekennzeichnet, dass** das Verfahren außerdem die folgenden Schritte H1), Z1) und W1) aufweist:
H1) Herstellen einer Funksignalverbindung von einer dritten Funk-Signalschnittstelle eines Bauteils (12) einer Vorrichtung (8) eines Flugzeugs (10) zu der zweiten Funk-Signalschnittstelle des Host-Systems (4), wobei in einer Speichereinheit des jeweiligen Bauteils (12) die zugehörige, eindeutige Teilnehmerkennung (14) des jeweiligen Bauteils (12), eine nicht-eindeutige Teilekennung (16) des jeweiligen Bauteils (12) und eine Initialschlüsselkennung (18) gespeichert sind, und wobei die Funksignalverbindung mittels der Initialschlüsselkennung (18) verschlüsselt wird;
Z1) Zuweisen und Übertragen einer neuen Schlüsselkennung von dem Host-System (4) an das Bauteil (12) über die Funksignalverbindung; und
W1) Neuherstellen einer neuen, mittels der neuen Schlüsselkennung verschlüsselten Funksignalverbindung von der dritten Funk-Signalschnittstelle des Bauteils (12) zu der zweiten Funk-Signalschnittstelle des Host-Systems (4).

13. Verfahren nach dem vorhergehenden Anspruch, **dadurch gekennzeichnet, dass** das Verfahren außerdem die folgenden Schritte aufweist:
R1) Empfang eines Resetsignals über die dritte Funk-Signalschnittstelle des Bauteils (12) oder einen Taster des Bauteils (12), und
R2) Zurücksetzen der Schlüsselkennung auf die in der Speichereinheit des Bauteils (12) gespeicherten Initialschlüsselkennung (18).

## Claims

1. Method for determining whether a plurality of components with communication capability in an aircraft can be used to clearly communicate, comprising the steps of:
T1) transmitting a configuration signal from a terminal (2) to a host system (4), the configuration signal representing at least one principal dataset,
each principal dataset representing precisely one related, unique apparatus identification (6) of a respective apparatus (8) of an aircraft (10) and comprising, for this respective apparatus (8), at least one auxiliary dataset that is uniquely associated with in each case precisely one component (12) of the respective apparatus (8),
each auxiliary dataset comprising a related, unique subscriber identification (14) of the respective component (12), a non-unique part identification (16) of the respective component (12) and an initial key identification (18),
the host system (4) storing a reference dataset (Soll) that comprises a multiplicity of apparatus identifications (6) and at least one associated, non-unique reference part identification for each apparatus identification (6);
E1) receiving the configuration signal by means of the host system (4);
S1) the host system (4) storing the at least one principal dataset received by means of the configuration signal;
(I1) identifying in the reference dataset, by means of the host system (4), the apparatus identification (6) of each principal dataset received by means of the configuration signal, and determining in the reference dataset, by means of the host system (4), the at least one non-unique reference part identification related to the identified apparatus identification (6);
V1) comparing the at least one part identification (16) comprised by the at least one auxiliary dataset of a respective principal dataset with the at least one reference part identification that was identified for the respective apparatus identification (6) of the respective principal dataset in step I1), by means of the host system (4); and
N1) generating and sending a report signal by means of the host system (4), as a result of which the report signal represents a result of the comparison from step V1), the report signal being readable to establish whether the apparatuses (8) installed in the aircraft (10), each of which has components with communication capability, are correctly installed.

2. Method according to the preceding claim, **characterized in that** in step V1) the host system (4) is used to check whether the part identifications (16) and reference part identifications to be compared with one another match, and the report signal is generated by means of the host system (4) in step N1) in such a way that the result represents a positive match if the check from step V1) yields no differences, and otherwise indicates the differing identifications (6, 14, 16, 18) by means of the report signal.

3. Method according to either of the preceding claims, **characterized in that** the configuration signal represents multiple principal datasets.

4. Method according to one of the preceding claims, **characterized in that** the terminal (2) is a fixed terminal (2) having a paper scanner.

5. Method according to one of preceding Claims 1 to 3, **characterized in that** the terminal (2) is a mobile terminal (2).

6. Method according to the preceding claim, **characterized in that** the mobile terminal (2) has a camera (20), the method additionally comprising the following steps K1), K2) and K3), which are performed before step T1):
K1) directly or indirectly, optically detecting an apparatus identification (6) on an apparatus (8) by means of the terminal (2); and
K2) directly or indirectly, optically detecting a subscriber identification (14), a non-unique part identification (16) and an initial key identification (18) on each component (12) of the apparatus (8) from step K1) by means of the terminal (2); and
K3) generating the principal dataset for each apparatus (8) from the related apparatus identification (6) detected in step K1), and the at least one related auxiliary dataset with the identifications (14, 16, 18) detected in step K2), by means of the terminal (2).

7. Method according to Claim 5, **characterized in that** the mobile terminal (2) has a near-field reader, the method additionally comprising the following steps K1), K2) and K3), which are performed before step T1):
K1) directly or indirectly, electromagnetically detecting an apparatus identification (6) on an apparatus (8) by means of the terminal (2); and
K2) directly or indirectly, electromagnetically detecting a subscriber identification (14), a non-unique part identification (16) and an initial key identification (18) on each component (12) of the apparatus (8) from step K1) by means of the terminal (2);
K3) generating the principal dataset for each apparatus (8) from the related apparatus identification (6) detected in step K1), and the at least one related auxiliary dataset with the identifications (14, 16, 18) detected in step K2), by means of the terminal (2).

8. Method according to one of preceding Claims 5 to 7, **characterized in that** in step T1) at least one principal dataset is transmitted from the terminal (2) to the host system (4) in each of multiple, successive time windows.

9. Method according to one of the preceding claims, **characterized in that** the terminal (2) has a first signal interface (22) and the host system (4) has a second signal interface (24), the signal interfaces (22, 24) being designed for transmitting a signal.

10. Method according to Claim 9, **characterized in that** the terminal (2) has a display (26) and the first signal interface (22) is designed for receiving the report signal, and wherein the method comprises the following steps:
R1) receiving the report signal by means of the first signal interface (22) of the terminal (2); and
A1) displaying a message, which optically represents the result of the comparison from step V1), on the basis of the report signal and by means of the display (26) of the terminal (2).

11. Method according to either of preceding Claims 9 and 10, **characterized in that** the first interface (22) and the second interface (24) are each in the form of a radio interface, the configuration signal being transmitted as a radio configuration signal in step T1), and the report signal being sent as a radio report signal in step N1).

12. Method according to one of preceding Claims 9 to 11, **characterized in that** the method additionally comprises the following steps H1), Z1) and W1):
H1) making a radio signal connection from a third radio signal interface of a component (12) of an apparatus (8) of an aircraft (10) to the second radio signal interface of the host system (4), a memory unit of the respective component (12) storing the related, unique subscriber identification (14) of the respective component (12), a non-unique part identification (16) of the respective component (12) and an initial key identification (18), and the radio signal connection being encrypted by means of the initial key identification (18);
Z1) assigning and transmitting a new key identification from the host system (4) to the component (12) by way of the radio signal connection; and
W1) remaking a new radio signal connection, encrypted by means of the new key identification, from the third radio signal interface of the component (12) to the second radio signal interface of the host system (4).

13. Method according to the preceding claim, **characterized in that** the method additionally comprises the following steps:
R1) receiving a reset signal by way of the third radio signal interface of the component (12) or a pushbutton switch of the component (12), and
R2) resetting the key identification to the initial key identification (18) stored in the memory unit of the component (12).

## Revendications

1. Procédé pour constater s'il est possible de communiquer de manière claire avec une pluralité de composants capables de communiquer dans un aéronef, comportant les étapes suivantes :
T1) transmission d'un signal de configuration d'un terminal (2) à un système hôte (4), le signal de configuration représentant au moins un jeu de données principal,
chaque jeu de données principal représentant exactement un identifiant de dispositif (6) clair associé d'un dispositif (8) respectif d'un aéronef (10) et comprenant pour ledit dispositif (8) respectif au moins un jeu de données auxiliaire, qui est associé clairement respectivement exactement à un composant (12) du dispositif (8) respectif,
chaque jeu de données auxiliaire comprenant un identifiant d'abonné (14) clair associé du composant (12) respectif, un identifiant partiel (16) non clair du composant (12) respectif et un identifiant de clé initial (18),
le système hôte (4) stockant un jeu de données de référence (théorique), qui comprend une pluralité d'identifiants de dispositif (6) et, pour chaque identifiant de dispositif (6), au moins un identifiant de partie de référence non clair associé ;
E1) réception du signal de configuration au moyen du système hôte (4) ;
S1) stockage de l'au moins un jeu de données principal reçu au moyen du signal de configuration du système hôte (4) ;
I1) identification de l'identifiant de dispositif (6) de chaque jeu de données principal, qui est reçu au moyen du signal de configuration, dans le jeu de données de référence au moyen du système hôte (4) et détermination de l'au moins un identifiant de partie de référence non clair associé à l'identifiant de dispositif (6) identifié dans le jeu de données de référence au moyen du système hôte (4) ;
V1) comparaison de l'au moins un identifiant partiel (16), qui est compris par l'au moins un jeu de données auxiliaire d'un jeu de données principal respectif, à l'au moins un identifiant partiel de référence, qui a été identifié dans l'étape I1) pour l'identifiant de dispositif (6) respectif du jeu de données principal respectif au moyen du système hôte (4) ; et
N1) génération et envoi d'un signal de rapport au moyen du système hôte (4), de telle sorte que le signal de rapport représente un résultat de la comparaison de l'étape V1), le signal de rapport pouvant être lu pour constater si les dispositifs (8) installés dans l'aéronef (10), comportant chacun des composants capables de communiquer, sont installés correctement.

2. Procédé selon la revendication précédente, **caractérisé en ce que**, dans l'étape V1), le système hôte (4) vérifie si les identifiants partiels (16) et les identifiants partiels de référence à comparer entre eux concordent, et le signal de rapport est généré dans l'étape N1) au moyen du système hôte (4) de telle manière que le résultat représente une concordance positive lorsque la vérification de l'étape V1) n'entraîne aucune différence, et le cas échéant, indique les identifiants (6, 14, 16, 18) qui diffèrent les uns des autres par le signal de rapport.

3. Procédé selon l'une des revendications précédentes, **caractérisé en ce que** le signal de configuration représente plusieurs jeux de données principaux.

4. Procédé selon l'une des revendications précédentes, **caractérisé en ce que** le terminal (2) est un terminal fixe (2) avec un scanner de papier.

5. Procédé selon l'une des revendications précédentes 1 à 3, **caractérisé en ce que** le terminal (2) est un terminal mobile (2).

6. Procédé selon la revendication précédente, **caractérisé en ce que** le terminal mobile (2) comporte une caméra (20), le procédé comportant également les étapes suivantes K1), K2) et K3), qui sont exécutées avant l'étape T1) :
K1) détection optique directe ou indirecte d'un identifiant de dispositif (6) sur un dispositif (8) au moyen du terminal (2) ; et
K2) détection optique directe ou indirecte d'un identifiant d'abonné (14), d'un identifiant partiel non clair (16) et d'un identifiant de clé initial (18) sur chaque composant (12) du dispositif (8) de l'étape K1) au moyen du terminal (2) ; et
K3) génération du jeu de données principal pour chaque dispositif (8) à partir de l'identifiant de dispositif (6) associé détecté dans l'étape K1) et de l'au moins un jeu de données auxiliaire associé avec les identifiants (14, 16, 18) détectés dans l'étape K2) au moyen du terminal (2).

7. Procédé selon la revendication 5, **caractérisé en ce que** le terminal mobile (2) comporte un lecteur de champ proche, le procédé comportant également les étapes suivantes K1), K2) et K3), qui sont exécutées avant l'étape T1) :
K1) détection électromagnétique directe ou indirecte d'un identifiant de dispositif (6) sur un dispositif (8) au moyen du terminal (2) ; et
K2) détection électromagnétique directe ou indirecte d'un identifiant d'abonné (14), d'un identifiant partiel non clair (16) et d'un identifiant de clé initial (18) sur chaque composant (12) du dispositif (8) de l'étape K1) au moyen du terminal (2) ;
K3) génération du jeu de données principal pour chaque dispositif (8) à partir de l'identifiant de dispositif (6) associé détecté dans l'étape K1) et de l'au moins un jeu de données auxiliaire associé avec les identifiants (14, 16, 18) détectés dans l'étape K2) au moyen du terminal (2).

8. Procédé selon l'une des revendications précédentes 5 à 7, **caractérisé en ce que** dans l'étape T1), respectivement au moins un jeu de données principal est transmis du terminal (2) au système hôte (4) dans plusieurs fenêtres temporelles successives.

9. Procédé selon l'une des revendications précédentes, **caractérisé en ce que** le terminal (2) comporte une première interface de signal (22) et le système hôte (4) comporte une deuxième interface de signal (24), les interfaces de signal (22, 24) étant formées pour transmettre un signal.

10. Procédé selon la revendication 9, **caractérisé en ce que** le terminal (2) comporte un affichage (26) et la première interface de signal (22) est formée pour recevoir le signal de rapport, et le procédé comportant les étapes suivantes :
R1) réception du signal de rapport au moyen de la première interface de signal (22) du terminal (2) ; et
A1) affichage d'un message, qui représente visuellement le résultat de la comparaison de l'étape V1) sur la base du signal de rapport et au moyen de l'affichage (26) du terminal (2).

11. Procédé selon l'une des revendications précédentes 9 à 10, **caractérisé en ce que** la première interface (22) et la deuxième interface (24) sont formées chacune comme une interface radio, le signal de configuration étant transmis sous la forme d'un signal de configuration radio dans l'étape T1) et le signal de rapport étant envoyé comme un signal de rapport radio dans l'étape N1).

12. Procédé selon l'une des revendications précédentes 9 à 11, **caractérisé en ce que** le procédé comporte par ailleurs les étapes suivantes H1), Z1) et W1) :
H1) établissement d'une liaison de signal radio à partir d'une troisième interface de signal radio d'un composant (12) d'un dispositif (8) d'un aéronef (10) avec la deuxième interface de signal radio du système hôte (4), l'identifiant d'abonné (14) clair associé du composant (12) respectif, un identifiant partiel non clair (16) du composant (12) respectif et un identifiant de clé initial (18) étant stockés dans une unité de stockage du composant (12) respectif, et la liaison de signal radio étant cryptée au moyen de l'identifiant de clé initial (18) ;
Z1) attribution et transmission d'un nouvel identifiant de clé du système hôte (4) au composant (12) par la liaison de signal radio ; et
W1) rétablissement d'une nouvelle liaison de signal radio chiffrée au moyen du nouvel identifiant de clé de la troisième interface de signal radio du composant (12) à la deuxième interface de signal radio du système hôte (4).

13. Procédé selon la revendication précédente, **caractérisé en ce que** le procédé comporte par ailleurs les étapes suivantes :
R1) réception d'un signal de réinitialisation par la troisième interface de signal radio du composant (12) ou un bouton du composant (12), et
R2) réinitialisation de l'identifiant de clé sur l'identifiant de clé initial (18) stocké dans l'unité de stockage du composant (12).
